# EUROPEAN PATENT APPLICATION

(11) **EP 4 773 439 A1**
(43) Date of publication of application: **08.07.2026**
(21) Application number: 24889012.1
(22) Date of filing: 29.10.2024
(51) Int. Cl.: H01Q 5/335, H01Q 5/50, H01Q 1/24, H04M 1/02, H01Q 1/38

(54) **ELECTRONIC DEVICE COMPRISING ANTENNA**

(30) Priority: 06.11.2023 KR 20230151592; 01.02.2024 KR 20240015757
(71) Applicant: Samsung Electronics Co., Ltd., Suwon-si, Gyeonggi-do 16677 (KR)
(72) Inventor: PARK, Sungkoo, Suwon-si, Gyeonggi-do 16677 (KR); KIM, Seunghwan, Suwon-si, Gyeonggi-do 16677 (KR); KIM, Haeyeon, Suwon-si, Gyeonggi-do 16677 (KR); NAM, Hojung, Suwon-si, Gyeonggi-do 16677 (KR); LEE, Kyungjae, Suwon-si, Gyeonggi-do 16677 (KR); LEE, Kookjoo, Suwon-si, Gyeonggi-do 16677 (KR); CHUN, Jaebong, Suwon-si, Gyeonggi-do 16677 (KR); HWANG, Soonho, Suwon-si, Gyeonggi-do 16677 (KR)
(74) Representative: Gulde & Partner
(86) International application number: PCT/KR2024/016626
(87) International publication number: WO 2025/100824

(57) **Abstract**

An electronic device according to various embodiments of the disclosure may include a hinge module, a first housing having at least a portion coupled to a first side of the hinge module, a printed circuit board which is disposed inside the first housing and includes a wireless communication module, a processor, and a ground, and a second housing having at least a portion coupled to a second side of the hinge module and configured to be unfoldable and foldable with respect to the first housing using the hinge module, wherein the first housing may include a first conductive portion, a second conductive portion, and a third conductive portion which are electrically connected to the wireless communication module, a first non-conductive portion disposed between the first conductive portion and the third conductive portion, and a second non-conductive portion disposed between the second conductive portion and the third conductive portion, the third conductive portion may be electrically connected to a first matching circuit through a first point, the first matching circuit may be electrically connected to the processor through a first electrical path, the processor may be configured to control an impedance of the first matching circuit to correspond to a first impedance while the first conductive portion operates to radiate signals in a first frequency band and the second conductive portion operates to radiate signals in the first frequency band, and the processor may be configured to control an impedance of the first matching circuit to correspond to a second impedance while the first conductive portion operates to radiate signals in a second frequency band and the second conductive portion operates to radiate signals in the second frequency band.

## Description

### [Technical Field]

Various embodiments of the disclosure provide an electronic device including at least one antenna.

### [Background Art]

The use of electronic devices, such as bar type, foldable type, rollable type, or sliding type smartphones or tablet personal computers (PCs) is increasing, and various functionalities are being provided to an electronic device.

The electronic device may transmit and receive phone calls and various data to and from another electronic device through wireless communication.

The electronic device may include at least one antenna to perform wireless communication with another electronic device using a network.

The above information is presented as background information only to assist with an understanding of the disclosure. No determination has been made, and no assertion is made, as to whether any of the above might be applicable as prior art with regard to the disclosure.

### [Disclosure of Invention]

### [Technical Problem]

In case of a bar type electronic device, at least a portion of a housing defining an exterior may include a conductive material (e.g., a metal). The at least a portion of the housing may be used as an antenna (or antenna radiator) for performing wireless communication. For example, the housing of the electronic device may use, as an antenna, at least one conductive portion separated through at least one non-conductive portion (e.g., a segment or slit).

For example, in case of a foldable electronic device, at least a portion of a first housing and second housing may include a conductive material (e.g., a metal). At least a portion of the first housing and the second housing may be used as an antenna (or antenna radiator) for performing wireless communication. For example, the first housing and/or the second housing of the foldable electronic device may use, as an antenna, at least one conductive portion separated through at least one non-conductive portion (e.g., a segment or slit).

The bar type electronic device or the foldable electronic device may include at least one antenna disposed at a lower end of the electronic device to transmit and receive phone calls or various data to and from another electronic device using a satellite.

For example, in case that a user grips the lower end of the electronic device, the radiation performance of the at least one antenna disposed at the lower end of the electronic device may deteriorate.

With respect to the electronic device, in case that antennas operating in a substantially identical frequency band are disposed adjacent to each other, interference between the antennas may be caused so as to deteriorate the radiation performance of the antennas.

Various embodiments of the disclosure may provide an electronic device capable of performing satellite communication using at least one antenna without interference.

The technical problems solved by the disclosure are not limited to the above technical problems and those skilled in the art to which the disclosure pertains will more clearly understand other technical problems from the following description.

### [Solution to Problem]

The electronic device according to an embodiment of the disclosure may include a hinge module, a first housing having at least a portion coupled to a first side of the hinge module, a printed circuit board which is disposed inside the first housing and includes a wireless communication module, a processor, and a ground, and a second housing having at least a portion coupled to a second side of the hinge module and configured to be unfoldable and foldable with respect to the first housing using the hinge module. According to an embodiment, the first housing may include a first conductive portion, a second conductive portion, and a third conductive portion electrically connected to the wireless communication module. According to an embodiment, the first housing may include a first non-conductive portion disposed between the first conductive portion and the third conductive portion and a second non-conductive portion disposed between the second conductive portion and the third conductive portion.

According to an embodiment, the third conductive portion may be electrically connected to a first matching circuit through a first point, and the first matching circuit may be electrically connected to the processor through a first electrical path. According to an embodiment, while the first conductive portion operates to radiate signals in a first frequency band and the second conductive portion operates to radiate signals in the first frequency band, the processor may be configured to control an impedance of the first matching circuit to correspond to a first impedance. According to an embodiment, while the first conductive portion operates to radiate signals in a second frequency band and the second conductive portion operates to radiate signals in the second frequency band, the processor may be configured to control an impedance of the first matching circuit to correspond to a second impedance.

The electronic device according to an embodiment of the disclosure may include a printed circuit board including a wireless communication module, a processor, and a ground inside a housing. According to an embodiment, the housing may include a first conductive portion, a second conductive portion, and a third conductive portion electrically connected to the wireless communication module. According to an embodiment, a first non-conductive portion may be located between the first conductive portion and the third conductive portion 530. According to an embodiment, a second non-conductive portion may be located between the second conductive portion and the third conductive portion. According to an embodiment, the third conductive portion may be electrically connected to a matching circuit through a first point, and the matching circuit may be electrically connected to the processor through an electrical path. According to an embodiment, while the first conductive portion operates to radiate signals in a first frequency band and the second conductive portion operates to radiate signals in the first frequency band, the processor may be configured to control an impedance of the matching circuit to correspond to a first impedance. According to an embodiment, while the first conductive portion operates to radiate signals in a second frequency band and the second conductive portion operates to radiate signals in the second frequency band, the processor may be configured to control an impedance of the matching circuit to correspond to a second impedance.

### [Advantageous Effects of Invention]

According to various embodiments of the disclosure, by controlling (e.g., adjusting) an impedance through a matching circuit of a third antenna disposed between a first antenna and a second antenna, interference between the first antenna and the second antenna may be reduced.

According to various embodiments of the disclosure, by controlling or adjusting an impedance of a third antenna (e.g., a legacy antenna) disposed adjacent to a first antenna (e.g., a satellite antenna), deterioration in the radiation performance of the first antenna may be reduced.

In addition, various effects directly or indirectly identified through the disclosure may be provided.

### [Brief Description of Drawings]

In connection with the description of the drawings, like or similar reference numerals may be used for like or similar elements.
FIG. 1 is a block diagram illustrating an electronic device in a network environment according to various embodiments of the disclosure.
FIGS. 2A and 2B are diagrams illustrating an unfolding state of a foldable electronic device viewed from a front surface and a rear surface according to various embodiments of the disclosure.
FIGS. 3A and 3B are diagrams illustrating a folding state of a foldable electronic device viewed from a front surface and a rear surface according to various embodiments of the disclosure.
FIG. 4 is an exploded perspective diagram schematically illustrating a foldable electronic device according to various embodiments of the disclosure.
FIG. 5 is a diagram schematically illustrating a partial configuration of a foldable electronic device including at least one non-conductive portion and at least one conductive portion according to an embodiment of the disclosure.
FIG. 6 is a diagram schematically illustrating a circuit configuration of a foldable electronic device including at least one switch and at least one matching circuit according to an embodiment of the disclosure.
FIG. 7 is a diagram schematically illustrating a configuration of a first switch or a second switch of the foldable electronic device shown in FIG. 6 according to an embodiment of the disclosure.
FIG. 8 is a diagram schematically illustrating a configuration of first to fourth matching circuits of the foldable electronic device shown in FIG. 6 according to an embodiment of the disclosure.
FIG. 9 is a diagram schematically illustrating a configuration of a first matching circuit or a second matching circuit of the foldable electronic device shown in FIG. 6 according to an embodiment of the disclosure.
FIG. 10 is a diagram schematically illustrating a configuration of a third matching circuit of the foldable electronic device shown in FIG. 6 according to an embodiment of the disclosure.
FIG. 11 is a diagram schematically illustrating a configuration of a fourth matching circuit of the foldable electronic device shown in FIG. 6 according to an embodiment of the disclosure.
FIG. 12A is a diagram schematically illustrating a radiation pattern in case that a first conductive portion of a foldable electronic device operates as a legacy antenna according to an embodiment of the disclosure.
FIG. 12B is a diagram schematically illustrating a radiation pattern in case that a first conductive portion of a foldable electronic device operates as a satellite antenna according to an embodiment of the disclosure.
FIG. 12C is a diagram schematically illustrating a change in radiation pattern of a first conductive portion according to a state change of a first matching circuit of a foldable electronic device according to an embodiment of the disclosure.
FIG. 13 is a diagram schematically illustrating an antenna characteristic according to a state change of a second matching circuit of a second conductive portion of a foldable electronic device according to an embodiment of the disclosure.
FIG. 14A is a diagram schematically illustrating a radiation pattern according to a state change of a first matching circuit in case that a first conductive portion of a foldable electronic device operates as a legacy antenna according to an embodiment of the disclosure.
FIG. 14B is a diagram schematically illustrating a radiation pattern according to a state change of a first matching circuit in case that a first conductive portion of a foldable electronic device operates as a satellite antenna according to an embodiment of the disclosure.
FIG. 15A is a diagram schematically illustrating a current distribution of a foldable electronic device according to a comparative example.
FIG. 15B is a diagram schematically illustrating a current distribution of a foldable electronic device according to an embodiment of the disclosure.
FIG. 15C is a diagram schematically illustrating a radiation pattern of the foldable electronic device shown in FIG. 15B according to an embodiment of the disclosure.
FIG. 16A is a diagram schematically illustrating radiation performance in case that a foldable electronic device is in an unfolding state according to an embodiment of the disclosure.
FIG. 16B is a diagram schematically illustrating radiation performance in case that a foldable electronic device is in a folding state according to an embodiment of the disclosure.
FIG. 17 is a flowchart schematically illustrating an operation of a foldable electronic device according to an embodiment of the disclosure.
FIG. 18 is a diagram schematically illustrating a circuit configuration of an electronic device including at least one switch and a matching circuit according to an embodiment of the disclosure.
FIG. 19 is a diagram schematically illustrating a circuit configuration of an electronic device including at least one switch and a matching circuit according to various embodiments of the disclosure.

### [Mode for the Invention]

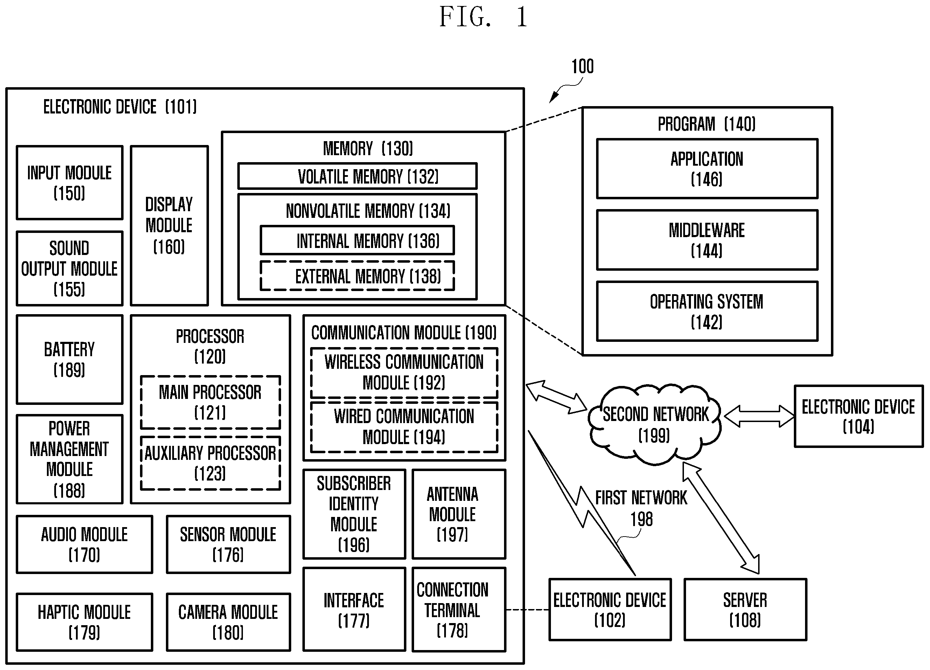

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196. The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

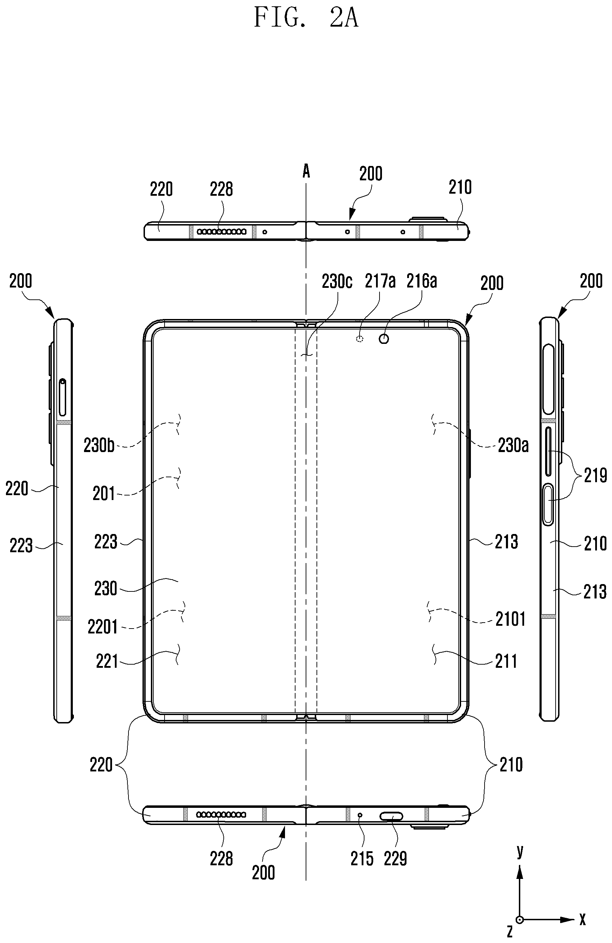

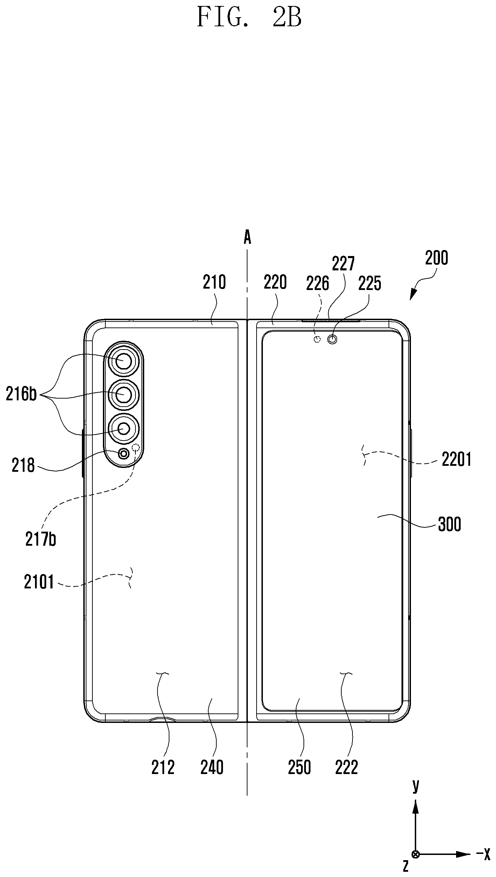

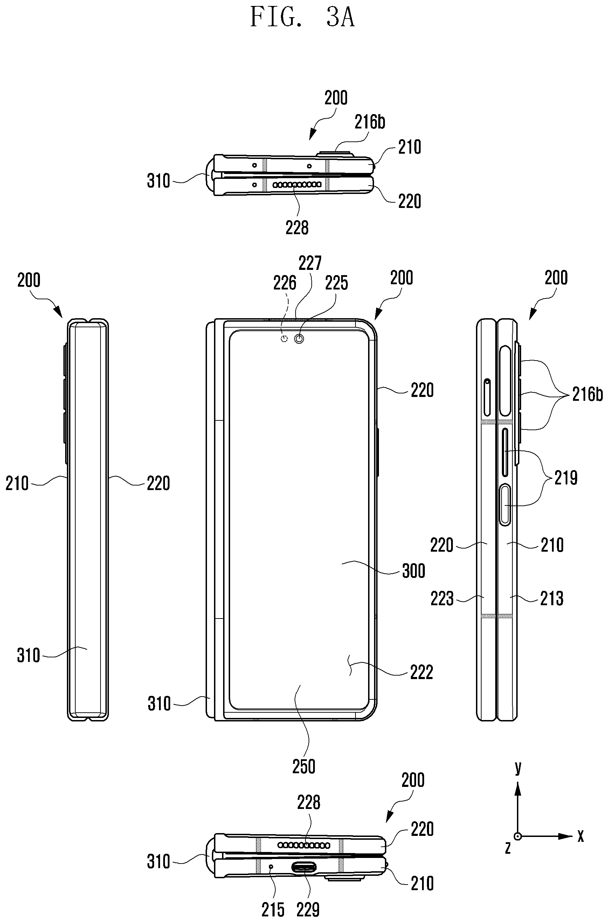

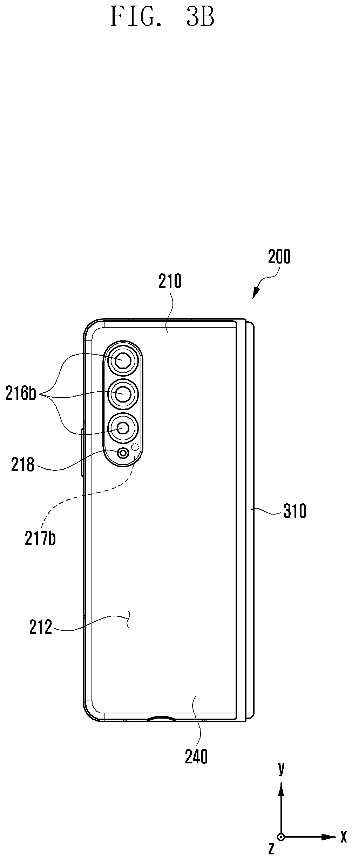

FIGS. 2A and 2B are diagrams illustrating an unfolding state of a foldable electronic device viewed from a front surface and a rear surface according to various embodiments of the disclosure. FIGS. 3A and 3B are diagrams illustrating a folding state of an electronic device viewed from a front surface and a rear surface according to various embodiments of the disclosure.

According to various embodiments, the embodiments shown in FIG. 1 may be included in embodiments disclosed in FIGS. 2A to 3B. For example, the foldable electronic device 200 shown in FIGS. 2A to 3B may include a processor 120, a memory 130, an input module 150, a sound output module 155, a display module 160, an audio module 170, a sensor module 176, an interface 177, a connection terminal 178, a haptic module 179, a camera module 180, a communication module 190, an antenna module 197, and/or a subscriber identification module 196 shown in FIG. 1.

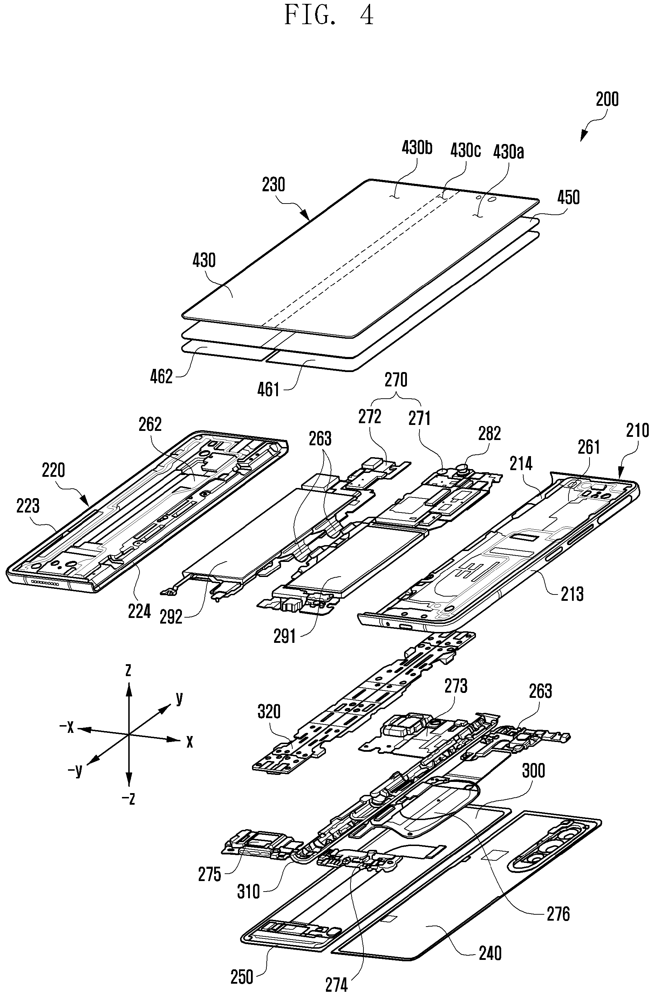

Referring to FIGS. 2A to 3B, the foldable electronic device 200 according to various embodiments of the disclosure may include a pair of housings 210 and 220 (e.g., a foldable housing structure) rotatably coupled to each other around a folding axis A through a hinge module (e.g., the hinge plate 320 in FIG. 4) (e.g., a hinge device) to be foldable with respect to each other, a flexible display 230 (e.g., a first display, a foldable display, or a main display) disposed through the pair of housings 210 and 220, and/or a sub-display 300 (e.g., a second display) disposed through a second housing 220.

According to various embodiments, at least a portion of the hinge module (e.g., the hinge plate 320 in FIG. 4) may be disposed not to be seen from the outside through a first housing 210 and the second housing 220 and disposed not to be seen through a hinge cover 310 (e.g., a hinge housing) configured to cover a foldable portion in the unfolded state. In the disclosure, a surface having the flexible display 230 disposed thereon may be defined as a front surface (e.g., the z-axis direction) of the foldable electronic device 200 and an opposite surface of the front surface may be defined as a rear surface (e.g., the -z-axis direction) of the foldable electronic device 200. A surface surrounding a space between the front surface and the rear surface may be defined as a lateral surface of the foldable electronic device 200.

According to various embodiments, the pair of housings 210 and 220 may include the first housing 210 and the second housing 220 arranged to be foldable with respect to each other through the hinge module (e.g., the hinge plate 320 in FIG. 4). The pair of housings 210 and 220 are not limited to the shape and combination described in FIGS. 2A to 3B, and may be implemented using another shape or a combination and/or coupling of components. The first housing 210 and the second housing 220 may be arranged on opposite sides around the folding axis A and may have substantially symmetric shapes with respect to the folding axis A. According to an embodiment, the first housing 210 and the second housing 220 may be folded to be asymmetric based on the folding axis A. An angle or distance between the first housing 210 and the second housing 220 may vary according to whether the foldable electric device 200 is in an unfolding state, a folding state, or an intermediate state.

According to various embodiments, in the unfolding state of the foldable electronic device 200, the first housing 210 may include a first surface 211 connected to the hinge module (e.g., the hinge plate 320 in FIG. 4) and disposed to face the front surface of the electronic device 200, a second surface 212 facing a direction opposite to the first surface 211, and/or a first lateral member 213 surrounding at least a portion of a first space between the first surface 211 and the second surface 212.

According to various embodiments, in the unfolding state of the foldable electronic device 200, the second housing 220 may include a third surface 221 connected to the hinge module (e.g., the hinge plate 320 in FIG. 4) and disposed to face the front surface of the foldable electronic device 200, a fourth surface 222 facing a direction opposite to the third surface 221, and/or a second lateral member 223 surrounding at least a portion of a second space between the third surface 221 and the fourth surface 222.

According to various embodiments, the first surface 211 may face a direction substantially identical to the third surface 221 in the unfolding state, and may at least partially face the third surface 221 in the folding state.

According to various embodiments, the foldable electronic device 200 may include a recess 201 configured to receive the flexible display 230 through a structural coupling of the first housing 210 and the second housing 220. The recess 201 may have a size substantially identical to that of the flexible display 230.

According to various embodiments, the hinge cover 310 (e.g., a hinge housing) may be disposed between the first housing 210 and the second housing 220. The hinge cover 310 may be disposed to cover a portion of the hinge module (e.g., the hinge plate 320 in FIG. 4). The hinge cover 310 may be covered by a portion of the first housing 210 and the second housing 220 or exposed to the outside depending of the unfolding state, folding state, or intermediate state of the foldable electronic device 200.

According to various embodiments, in case that the foldable electronic device 200 is in the unfolding state, at least a portion of the hinge cover 310 may be covered by the first housing 210 and the second housing 220 and not substantially exposed. In case that the foldable electronic device 200 is in the folding state, at least a portion of the hinge cover 310 may be exposed to the outside between the first housing 210 and the second housing 220. In the intermediate state in which the first housing 210 and the second housing 220 are folded with a certain angle, the hinge cover 310 may be at least partially exposed to the outside of the foldable electronic device 200 between the first housing 210 and the second housing 220. For example, an area through which the hinge cover 310 is exposed to the outside may be smaller than that of a completed folding state. The hinge cover 310 may at least partially include a curved surface.

According to various embodiments, in case that the foldable electronic device 200 is in the unfolding state (e.g., the state in FIGS. 2A and 2B), the first housing 210 and the second housing 220 may form an angle of 180° therebetween, and a first area 230a, a second area 230b, and a folding area 230c of the flexible display 230 may be arranged to define the same plane and to face substantially the same direction (e.g., the z-axis direction). In another embodiment, in case that the foldable electronic device 200 is in the unfolding state, the first housing 210 may rotate at an angle of about 360° with respect to the second housing 220 to be reversely folded (e.g., an out-folding method) so that the second surface 212 and the fourth surface 222 face each other.

According to various embodiments, in case that the foldable electronic device 200 is in the folding state (e.g., the state in FIGS. 3A and 3B), the first surface 211 of the first housing 210 and the third surface 221 of the second housing 220 may be arranged to face each other. Here, the first area 230a and the second area 230b of the flexible display 230 may be arranged to face each other while configuring a narrow angle (e.g., a range of 0 degrees to about 10 degrees) therebetween through the folding area 230c.

According to various embodiments, at least a portion of the folding area 231c may be changed to have a curved shape having a certain curvature. In case that the foldable electronic device 200 is in the intermediate state, the first housing 210 and the second housing 220 may be arranged to have a certain angle therebetween. In this case, the first area 230a and the second area 230b of the flexible display 230 may configure an angle larger than that of the folding state and smaller than that of the unfolding state, and the curvature of the folding area 230c may be smaller than that of the folding state and larger than that of the unfolding state.

According to various embodiments, the first housing 210 and the second housing 220 may configure an angle that may stop at a specified folding angle between the folded state and the unfolded state through the hinge module (e.g., the hinge plate 320 in FIG. 4) (e.g., a free stop function). In some embodiments, the first housing 210 and the second housing 220 may be continuously operated while being pressurized in an unfolding direction or a folding direction based on a designated inflection angle, through the hinge module (e.g., the hinge plate 320 in FIG. 4).

According to various embodiments, the foldable electronic device 200 may include at least one of at least one display (e.g., the flexible display 230 or the sub-display 300) disposed in the first housing 210 and/or the second housing 220, an input device 215, an audio output module 227 or 228, a sensor module 217a, 217b, or 226, a camera module 216a, 216b, or 225, a key input device 219, an indicator (not shown), or a connector port 229. In some embodiments, the foldable electronic device 200 may omit at least one of the components described above or may additionally include at least one other component.

According to various embodiments, the at least one display (e.g., the flexible display 230 or the sub-display 300) may include the flexible display 230 (e.g., a first display) disposed from the first surface 211 of the first housing 210 to be supported by the third surface 221 of the second housing 220 through the hinge module (e.g., the hinge plate 320 in FIG. 4) and the sub-display 300 (e.g., a second display) disposed to be at least partially seen from the outside through the fourth surface 222 within an internal space of the second housing 220. In some embodiments, the sub-display 300 may be disposed within an internal space of the first housing 210 to be seen from the outside through the second surface 212. According to an embodiment, the flexible display 230 may be mainly used in the unfolding state of the foldable electronic device 200 and the sub-display 300 may be mainly used in the folding state of the foldable electronic device 200. According to an embodiment, in case that the foldable electronic device 200 is in the intermediate state, the foldable electronic device may control the flexible display 230 and/or the sub-display 300 to be usable based on a folding angle of the first housing 210 and the second housing 220.

According to various embodiments, the flexible display 230 may be disposed in a reception space configured by the pair of housings 210 and 220. For example, the flexible display 230 may be disposed in the recess 201 configured by the pair of housings 210 and 220, and may be disposed to occupy substantially most of the front surface of the foldable electronic device 200 in the unfolding state. According to an embodiment, at least a portion of the flexible display 230 may be transformed to have a flat surface or a curved surface. The flexible display 230 may include the first area 231a facing the first housing 210, a second area 230b facing the second housing 220, and a folding area 230c configured to connect the first area 230a and the second area 230b and facing the hinge module (e.g., the hinge plate 320 in FIG. 4). According to an embodiment, the area division of the flexible display 230 is an exemplary physical division by the pair of housings 210 and 220 and the hinge module (e.g., the hinge plate 320 in FIG. 4), and the flexible display 230 may be displayed as a substantially seamless single full screen through the pair of housings 210 and 220 and the hinge module (e.g., the hinge plate 320 in FIG. 4). The first area 230a and the second area 230b may have an overall symmetrical shape or a partially asymmetrical shape based on the folding area 230c.

According to various embodiments, the foldable electronic device 200 may include a first rear cover 240 disposed on the second surface 212 of the first housing 210 and a second rear cover 250 disposed on the fourth surface 222 of the second housing 220. In some embodiments, at least a portion of the first rear cover 240 may be integrally formed with the first lateral member 213. In some embodiments, at least a portion of the second rear cover 250 may be integrally formed with the second lateral member 223. According to an embodiment, at least one of the first rear cover 240 and the second rear cover 250 may be made of a substantially transparent plate (e.g., a polymer plate or a glass plate including various coating layers) or an opaque plate.

According to various embodiments, the first rear cover 240 may be made of an opaque plate such as, for example, coated or tinted glass, ceramic, polymer, a metal (e.g., aluminum, stainless steel (STS), or magnesium), or a combination of at least two of the materials. The second rear cover 250 may be configured through a substantially transparent plate such as glass or polymer. Here, the second display 300 may be disposed within an internal space of the second housing 220 to be seen from the outside through the second rear cover 250.

According to various embodiments, the input module 215 may include a microphone. In some embodiments, the input module 215 may include multiple microphones arranged to detect a direction of a sound. The input module 215 may include the input module 150 shown in FIG. 1.

According to various embodiments, the audio output module 227 or 228 may include speakers. According to an embodiment, the audio output module 227 or 228 may include a call receiver disposed through the fourth surface 222 of the second housing 220 and an external speaker disposed through at least a portion of the second lateral member 223 of the second housing 220. In some embodiments, the input module 215, the audio output module 227 or 228, and a connector 229 may be disposed in spaces of the first housing 210 and/or the second housing 220 and may be exposed to an external environment through at least one hole disposed through the first housing 210 and/or the second housing 220. In some embodiments, holes disposed through the first housing 210 and/or the second housing 220 may be commonly used for the input module 215 and the audio output module 227 or 228. In some embodiments, the audio output module 227 and 228 may include a speaker (e.g., a piezo speaker) operating without a hole disposed through the first housing 210 and/or the second housing 220. The audio output module 227 or 228 may include the audio output module 155 shown in FIG. 1.

According to various embodiments, the camera module 216a, 216b, or 225 may include a first camera module 216a disposed on the first surface 211 of the first housing 210, a second camera module 216b disposed on the second surface 212 of the first housing 210, and/or a third camera module 225 disposed on the fourth surface 222 of the second housing 220. According to an embodiment, the foldable electronic device 200 may include a flash 218 located adjacent to the second camera module 216b. The flash 218 may include, for example, a light-emitting diode or a xenon lamp. According to an embodiment, the camera modules 216a, 216b, and 225 may include one or more of lenses, an image sensor, and/or an image signal processor. In some embodiments, at least one of the camera modules 216a, 216b, and 225 may include two or more lenses (e.g., a wide-angle and telephoto lens) and image sensors and may be disposed on one surface of the first housing 210 and/or the second housing together with same. The camera module 216a, 216b, or 225 may include the camera module 180 shown in FIG. 1.

According to various embodiments, the sensor module 217a, 217b, or 226 may generate an electrical signal or a data value corresponding to an internal operation state or external environment state of the foldable electronic device 200. According to an embodiment, the sensor module 217a, 217b, or 226 may include a first sensor module 217a disposed on the first surface 211 of the first housing 210, a second sensor module 217b disposed on the second surface 212 of the first housing 210, and/or a third sensor module 226 disposed on the fourth surface 222 of the second housing 220. In some embodiments, the sensor module 217a, 217b, or 226 may include at least one of a gesture sensor, a grip sensor, a color sensor, an infrared (IR) sensor, an illumination sensor, an ultrasonic sensor, an iris recognition sensor, or a distance detection sensor (e.g., a time of flight (TOF) sensor or a light detection and ranging (LiDAR) sensor). The sensor module 217a, 217b, or 226 may include the sensor module 176 shown in FIG. 1.

According to various embodiments, the foldable electronic device 200 may further include a sensor module not shown, for example, at least one of a barometric pressure sensor, a magnetic sensor, a biometric sensor, a temperature sensor, a humidity sensor, a hall sensor, a 6-axis sensor, an acceleration sensor, an angular velocity sensor, and fingerprint recognition sensor. In some embodiments, the fingerprint recognition sensor may be disposed through at least one of the first lateral member 213 of the first housing 210 and/or the second lateral member 223 of the second housing 220.

According to various embodiments, the key input device 219 may be disposed to be exposed to the outside through the first lateral member 213 of the first housing 210. In some embodiments, the key input device 219 may be disposed to be exposed to the outside through the second lateral member 223 of the second housing 220. In some embodiments, the foldable electronic device 200 may not include a portion or entirety of key input device 219, and the excluded key input device 219 may be implemented as various forms, such as a soft key, on the at least one display 230 or 300. In another embodiment, the key input device 219 may be implemented using a pressure sensor included in the at least one display 230 or 300. The key input device 219 may turn the power of the foldable electronic device 200 on or off, or adjust the volume.

According to various embodiment, the connector port 229 may include a connector (e.g., a USB connector or an interface connector port module) configured to transmit or receive power and/or data to or from an external electronic device (e.g., the external electronic device 102, 104, or 108 in FIG. 1). In some embodiments, the connector port 229 may concurrently perform a function to transmit or receive an audio signal to or from an external electronic device or may further include a separate connector port (e.g., an ear jack hole) to perform a function to transmit or receive an audio signal. The connector port 229 may include the connection terminal 178 shown in FIG. 1.

According to various embodiments, at least one camera module 216a or 225 among the camera modules 216a, 216b, and 225, at least one sensor module 217a or 226 among the sensor modules 217a, 217b, and 226, and/or the indicator may be arranged to be exposed through the at least one display 230 or 300. For example, at least one camera module 216a or 225, at least one sensor module 217a or 226, and/or the indicator may be arranged under an activation area (display area) of the at least one display 230 or 300 within an internal space of at least one housing 210 or 220 and may be arranged to be in contact with the external environment through a transparent area or an opening perforated through a cover member (e.g., a window layer (not shown) of the flexible display 230 and/or the second rear cover 250). According to an embodiment, an area in which the at least one display 230 or 300 and the at least camera module 216a or 225 face each other may be a portion of an area configured to display contents, and may be configured as a transmission area having predetermined transmittance. According to an embodiment, the transmission area may be configured to have transmittance in a range of about 5% to about 20%. The transmission area may include an area overlapping an effective area (e.g., a view-angle region) of the at least one camera module 216a or 225 through which light for imaging to an image sensor to generate an image passes. For example, the transmission area of the at least one display 230 or 300 may include an area having a lower pixel density than a peripheral area. For example, the transmission area may be substituted with the opening. For example, the at least one camera module 216a or 225 may include an under-display camera (UDC) or an under panel camera (UPC). In another embodiment, some of camera modules or sensor modules 217a and 226 may not be visually exposed through the display and may be disposed to perform functions thereof. For example, an area facing the camera module 216a or 225 and/or the sensor module 217a or 226 disposed under the at least one display 230 or 300 may have an under-display camera structure and may not need a perforated opening.

FIG. 4 is an exploded perspective diagram schematically illustrating a foldable electronic device according to various embodiments of the disclosure.

Referring to FIG. 4, the foldable electronic device 200 may include a flexible display 230 (e.g., a first display), a sub-display 300 (e.g., a second display), a hinge plate 320 (e.g., a hinge module), a pair of support members (e.g., a first support member 261 or a second support member 262), at least one substrate (e.g., a printed circuit board (PCB) 270), a first housing 210, a second housing 220, a first rear cover 240, and/or a second rear cover 250.

According to various embodiments, the flexible display 230 may include a display panel 430 (e.g., a flexible display panel), a support plate 450 disposed on a lower part (e.g., the -z-axis direction) of the display panel 430, and a pair of metal plates 461 and 462 disposed on a lower part (e.g., the z-axis direction) of the support plate 450.

According to various embodiments, the display panel 430 may include a first panel area 430a corresponding to a first area (e.g., the first area 230a in FIG. 2A) of the flexible display 230, a second panel area 430b extending from the first panel area 430a and corresponding to a second area (e.g., the second area 230b in FIG. 2A) of the flexible display 230, and a third panel area 430c configured to connect the first panel area 430a and the second panel area 430b and corresponding to a folding area (e.g., the folding area 230c in FIG. 2A) of the flexible display 230.

According to various embodiments, the support plate 450 may be disposed between the display panel 430 and the pair of support members 261 and 262 and may be configured to have a material or shape to provide a planar support structure for the first panel area 430a and the second panel area 430b and a curved structure to help with curvature of the third panel area 430c. According to an embodiment, the support plate 450 may be made of a conductive material (e.g., a metal) or a non-conductive material (e.g., polymer or fiber reinforced plastic (FRP)). According to an embodiment, the pair of metal plates 461 and 462 may include a first metal plate 461 disposed to correspond to at least a portion of the first panel area 430a and the third panel area 430c between the support plate 450 and the pair of support members 261 and 262 and a second metal plate 462 disposed to correspond to at least a portion of the second panel area 430b and the third panel area 430c. According to an embodiment, the pair of metal plates 461 and 462 may be made of a metal (e.g., SUS) to help reinforce a ground connection structure and stiffness for the flexible display 230.

According to various embodiments, the sub-display 300 may be disposed in a space between the second housing 220 and the second rear cover 250. According to an embodiment, the sub-display 300 may be disposed within a space between the second housing 220 and the second rear cover 250 to be seen from the outside through a substantially entire area of the second rear cover 250.

According to various embodiments, at least a portion of the first support member 261 may be foldably coupled to the second support member 262 through the hinge plate 320 (e.g., a hinge module). According to an embodiment, the foldable electronic device 200 may include at least one wire member 263 (e.g., a flexible printed circuit board (FPCB)) disposed from at least a portion of the first support member 261 across the hinge plate 320 to a portion of the second support member 262. According to an embodiment, the first support member 261 may be disposed in a manner extending from the first lateral member 213 or structurally coupled to the first lateral member 213. According to an embodiment, the foldable electronic device 200 may include a first space (e.g., the first space 2101 in FIG. 2A) provided through the first support member 261 and the first rear cover 240.

According to various embodiments, the first housing 210 (e.g., a first housing structure) may be configured through coupling of the first lateral member 213, the first support member 261, and the first rear cover 240. According to an embodiment, the second support member 262 may be disposed in a manner extending from the second lateral member 223 or structurally coupled to the second lateral member 223. According to an embodiment, the foldable electronic device 200 may include a second space (e.g., the second space 2201 in FIG. 2A) provided through the second support member 262 and the second rear cover 250.

According to various embodiments, the second housing 220 (e.g., a second housing structure) may be configured through coupling of the second lateral member 223, the second support member 262, and the second rear cover 250. According to an embodiment, at least a portion of the at least one wire member 263 and/or the hinge plate 320 may be disposed to be supported through at least a portion of the pair of support members 261 and 262. According to an embodiment, the at least one wire member 263 may be disposed in a direction (e.g., the x-axis direction) crossing the first support member 261 and the second support member 262. According to an embodiment, the at least one wire member 263 may be disposed in a direction (e.g., x-axis direction) substantially perpendicular to a folding axis (e.g., the y-axis or the folding axis A in FIG. 2A).

According to various embodiments, the at least one substrate 270 may include a first substrate 271 (e.g., a first printed circuit board) disposed in the first space 2101 and a second substrate 272 (a second printed circuit board) disposed in the second space 2201. According to an embodiment, the first substrate 271 and the second substrate 272 may include at least one electronic component disposed to implement various functions of the foldable electronic device 200. According to an embodiment, the first substrate 271 and the second substrate 272 may be electrically connected through the at least one wire member 263. In an embodiment, the camera module 282 may be disposed on the first substrate 271.

According to various embodiments, the foldable electronic device 200 may include at least one battery 291 or 292. According to an embodiment, the at least one battery 291 or 292 may include a first battery 291 disposed in the first space 2101 of the first housing 210 and electrically connected to the first substrate 271 and a second battery 292 disposed in the second space 2201 of the second housing 220 and electrically connected to the second substrate 272. According to an embodiment, the first support member 261 and the second support member 262 may further include at least one swelling hole for the first battery 291 and the second battery 292.

According to various embodiments, the first housing 210 may include a first rotation support surface 214 and the second housing 220 may include a second rotation support surface 224. According to an embodiment, the first rotation support surface 214 and the second rotation support surface 224 may each include a curved surface corresponding to a curved external surface of the hinge cover 310. According to an embodiment, in case that the foldable electronic device 200 is in the unfolding state, the first rotation support surface 214 and the second rotation support surface 224 may cover the hinge cover 310 so that the hinge cover 310 may not be exposed to the rear surface of the foldable electronic device 200 or a portion thereof may be exposed. According to an embodiment, in case that the foldable electronic device 200 is in the folding state, the first rotation support surface 214 and the second rotation support surface 224 may rotate along the curved external surface of the hinge cover 310 so that the hinge cover 310 may be at least partially exposed to the rear surface of the foldable electronic device 200.

According to various embodiments, the foldable electronic device 200 may include at least one antenna 276 disposed in the first space 2201. According to an embodiment, the at least one antenna 276 may be disposed between the first battery 291 and the first rear cover 240 within the first space 2201. According to an embodiment, the at least one antenna 276 may include, for example, a near field communication (NFC) antenna, a wireless charging antenna, and/or a magnetic secure transmission (MST) antenna. According to an embodiment, the at least one antenna 276 may wirelessly transmit and receive power required for charging or perform near field communication with an external device, for example. In some embodiments, an antenna structure may be configured by at least a portion of the first lateral member 213 or the second lateral member 223 and/or a part or a combination of the first support member 261 and the second support member 262.

According to various embodiments, the foldable electronic device 200 may further include at least one electronic component assembly 274 or 275 and/or additional support members 263 and 273 disposed in the first space 2101 and/or the second space 2201. For example, the at least one electronic component assembly 274 or 275 may include an interface connector port assembly 274 or a speaker assembly 275.

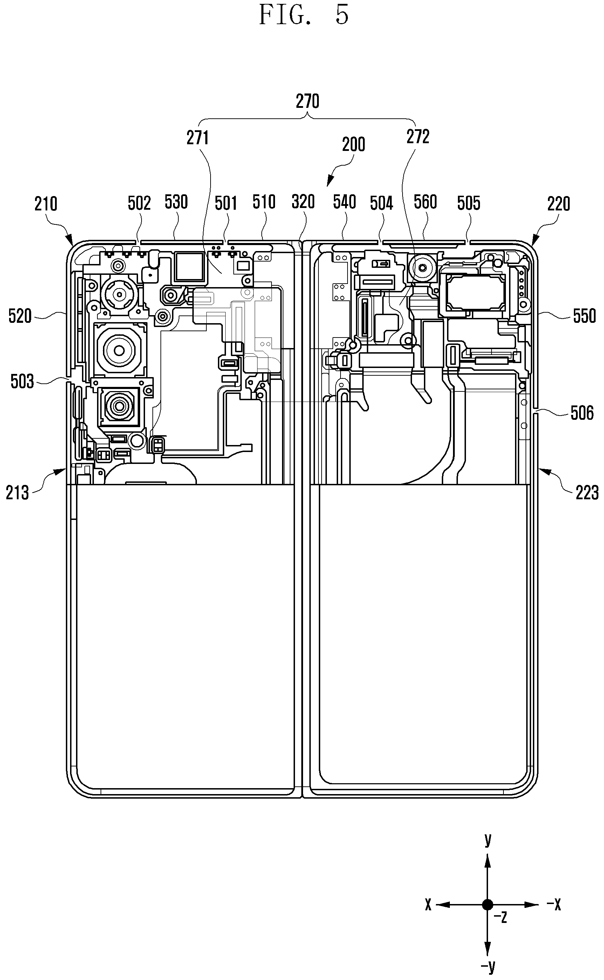

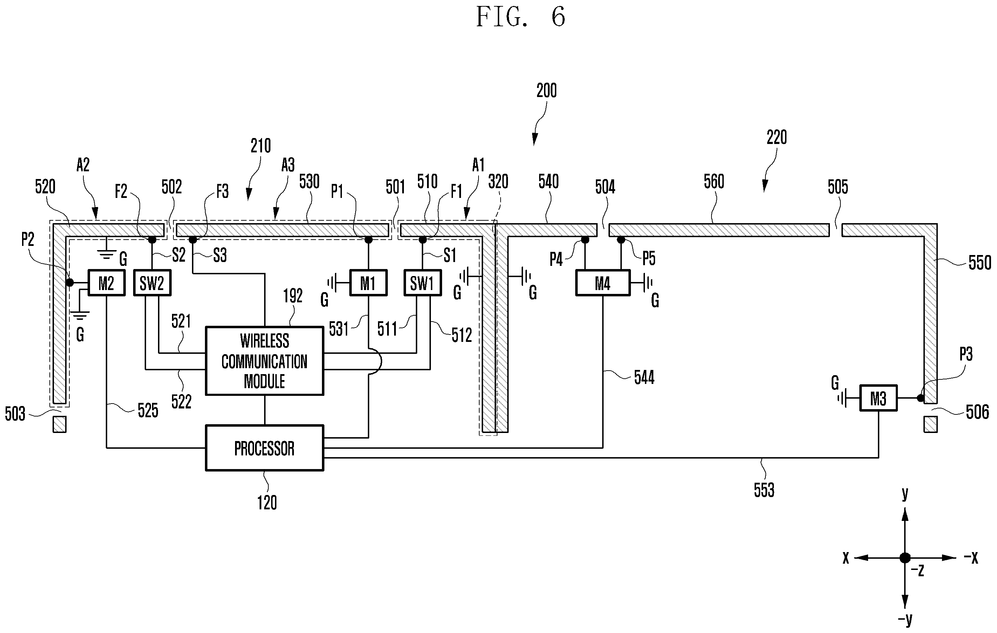

FIG. 5 is a diagram schematically illustrating a partial configuration of a foldable electronic device including at least one non-conductive portion and at least one conductive portion according to an embodiment of the disclosure. FIG. 6 is a diagram schematically illustrating a circuit configuration of a foldable electronic device including at least one switch and at least one matching circuit according to an embodiment of the disclosure.

According to various embodiments, the foldable electronic device 200 described below may include the electronic device 101 shown in FIG. 1 and the foldable electronic device 200 shown in FIGS. 2A to 4. With respect to the description of the foldable electronic device 200 below, identical numerals may be used for substantially identical elements of the embodiments disclosed in FIGS. 1 to 4, and overlapping description with respect to the functions thereof may be omitted.

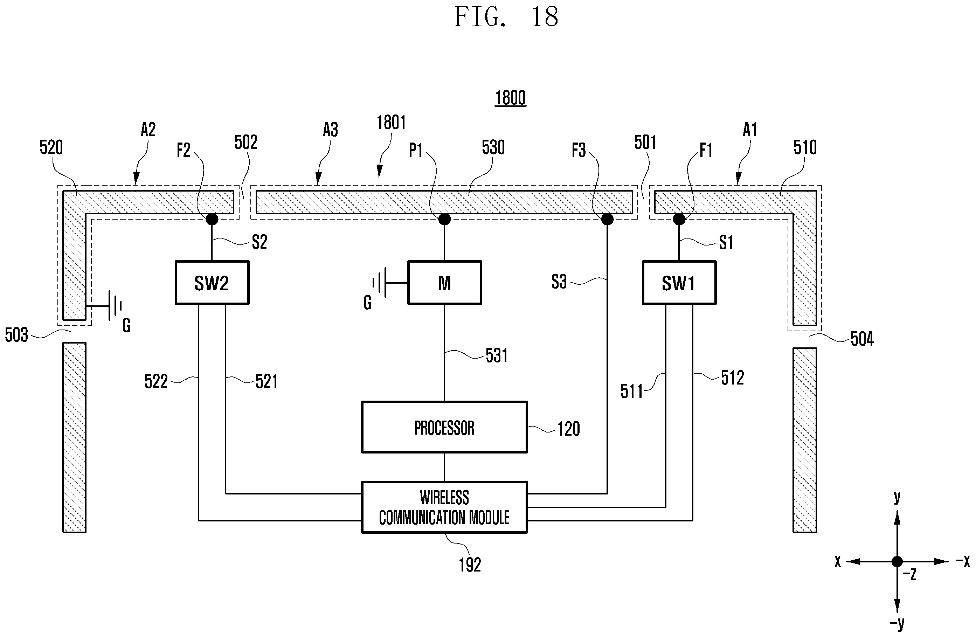

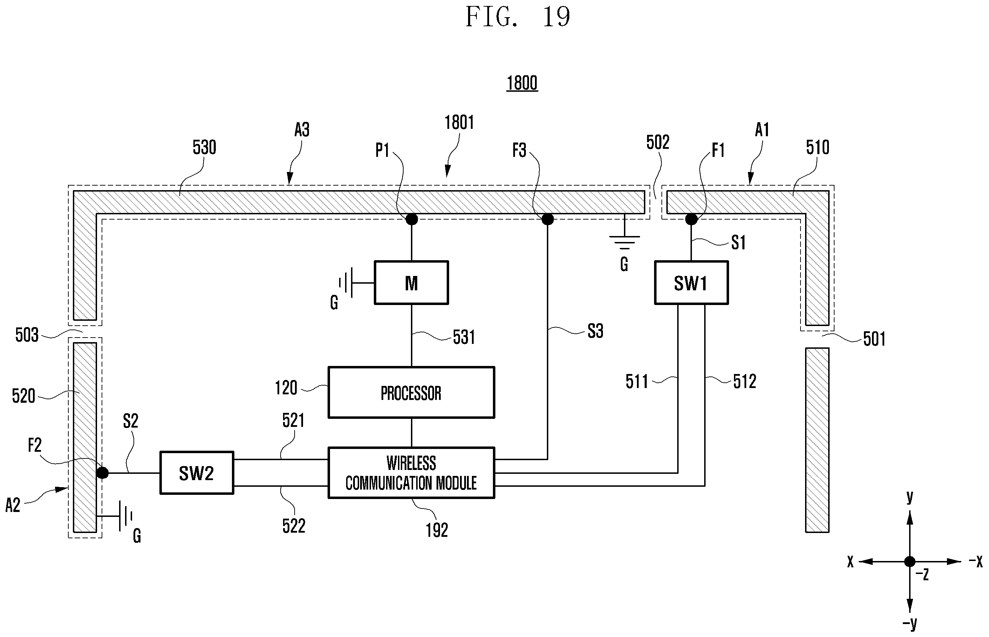

According to an embodiment, embodiments disclosed below are described using the foldable electronic device 200 as an example, but without limitation thereto, the embodiments may be substantially identically applied to an electronic device such as a bar-type electronic device (e.g., the electronic device 1800 in FIGS. 18 and 19), a rollable type device, a sliding type device, a tablet PC, and/or a laptop PC.

According to an embodiment, the embodiments related to the foldable electronic device 200 shown in FIG. 5 describe a structure in which the first housing 210 and the second housing 220 are unfolded and folded in the horizontal direction (e.g., the x-axis direction and the -x-axis direction), but without limitation thereto, the embodiments may be substantially identically applied to a foldable electronic device having a structure of being unfolded or folded in the vertical direction (e.g., the y-axis direction and the -y-axis direction).

According to an embodiment, FIG. 5 may be a diagram schematically illustrating a partial configuration of the hinge module 320, the first housing 210, and the second housing 220 viewed from the rear surface (e.g., the -z-axis direction) in case that the foldable electronic device 200 shown in FIG. 2B is in the unfolding state according to an embodiment of the disclosure.

Referring to FIGS. 5 and 6, the foldable electronic device 200 may include a hinge module 320 (e.g., the hinge plate 320 in FIG. 4), a first housing 210, and a second housing 220.

According to an embodiment, the first housing 210 and the second housing 220 may operate in the unfolding state or folding state based on the hinge module 320 as shown in FIGS. 2A to 3B. The hinge module 320 may be rotatably coupled to the first housing 210 and the second housing 220.

According to an embodiment, at least a portion of the first housing 210 may be coupled to a first side (e.g., the x-axis direction) of the hinge module 320. At least a portion of the second housing 220 may be coupled to a second side (e.g., the -x-axis direction) of the hinge module 320. The first housing 210 may be configured to be unfolded or folded with respect to the second housing 220 using the hinge module 320. The second housing 220 may be configured to be unfolded or folded with respect to the first housing 210 using the hinge module 320. For example, the first housing 210 may include a first lateral member 213. For example, the second housing 220 may include a second lateral member 223.

According to an embodiment, the first housing 210 and the second housing 220 may include a printed circuit board 270. For example, the first housing 210 may include a first printed circuit board 271. For example, the second housing 220 may include a second printed circuit board 272. In an embodiment, a wireless communication module 192, a processor 120, and a ground G (e.g., a grounding part) may be disposed on a printed circuit board 270. In various embodiments, at least one wireless communication module 192, at least one processor 120, and at least one ground G may be disposed on the printed circuit board 270.

According to various embodiments, at least one memory 130 may be disposed on the printed circuit board 270. The memory 130 may perform functions of storing a program (e.g., the program 140 in FIG. 1A) configured for processing and controlling of the processor 120, an operation system (e.g., the operation system 142 in FIG. 1A), various applications, and input/output data. The memory 130 may store a program configured to control overall operations of the foldable electronic device 200. The memory 130 may store various configuration information required when the foldable electronic device 200 processes a function. The memory 130 may store at least one executable instruction. For example, the memory 130 may store at least one instruction, when executed by the processor 120, cause the foldable electronic device 200 to perform at least one operation. For example, at least one instruction may be stored in a computer-readable recording medium. The recording medium may be tangible and non-transitory. The memory 130 and/or the recording medium may store at least one program including at least one instruction.

According to an embodiment, the first lateral member 213 may include a first non-conductive portion 501, a second non-conductive portion 502, a first conductive portion 510, a second conductive portion 520, and/or a third conductive portion 530. For example, the first non-conductive portion 501 may be located between the first conductive portion 510 and the third conductive portion 530. For example, the second non-conductive portion 502 may be located between the second conductive portion 520 and the third conductive portion 530. For example, the third conductive portion 530 may be located between the first non-conductive portion 501 and the second non-conductive portion 502. According to various embodiments, the first lateral member 213 may include a third non-conductive portion 503. For example, the second conductive portion 520 may be located between the second non-conductive portion 502 and the third non-conductive portion 503.

In various embodiments disclosed in the disclosure, the first non-conductive portion 501 may include a segment or a slit. The second non-conductive portion 502 may include a segment or a slit. The third non-conductive portion 503 may include a segment or a slit. The fourth non-conductive portion 504 may include a segment or a slit. A fifth non-conductive portion 505 may include a segment or a slit. A sixth non-conductive portion 506 may include a segment or a slit.

According to an embodiment, the first housing 210 may include a first non-conductive portion 501 (e.g., a first segment), a second non-conductive portion 502 (e.g., a second segment), a third non-conductive portion 503 (e.g., a third segment), a first conductive portion 510, a second conductive portion 520, and/or a third conductive portion 530. For example, the first non-conductive portion 501, the second non-conductive portion 502, and/or the third non-conductive portion 503 may be disposed on the first lateral member 213 of the first housing 210. For example, the first non-conductive portion 501 and the second non-conductive portion 502 may be disposed in an upper direction (e.g., the y-axis direction) of the first lateral member 213. The third non-conductive portion 503 may be disposed in the x-axis direction of the first lateral member 213. For example, the first non-conductive portion 501 may be disposed closer to the hinge module 320 than to the second non-conductive portion 502 and the third non-conductive portion 503.

According to an embodiment, the first conductive portion 510 may be disposed between the first non-conductive portion 501 and the hinge module 320. The first conductive portion 510 may be electrically connected to the wireless communication module 192 (e.g., an RFIC). For example, the first conductive portion 510 may be electrically connected to the wireless communication module 192 through a first feeding point F1 and a first signal path S1. The first conductive portion 510 may function as a radiator of the first antenna A1. For example, the first antenna A1 may include the first conductive portion 510. For example, the wireless communication module 192 may be electrically connected to the first feeding point F1 by using a conductive member (e.g., a contact pad, a coupling member, a C-clip, or conductive foam spring). In an embodiment, the first antenna A1 (e.g., the first conductive portion 510) may operate in a first frequency band (e.g., a legacy frequency band) or a second frequency band (e.g., a satellite frequency band). For example, the first frequency band may include frequency bands of about 650 MHz to 5 GHz. For example, the second frequency band may include frequency bands of about 1.5 GHz to 1.7 GHz. For example, the first antenna A1 (e.g., the first conductive portion 510) may operate as a legacy antenna or a satellite antenna. For example, the first conductive portion 510 may transmit and receive a wireless frequency signal. For example, the first conductive portion 510 may operate to radiate signals in the first frequency band or signals in the second frequency band. For example, the first antenna A1 may operate in a frequency band substantially identical to or different from that of the second antenna A2.

According to an embodiment, a first switch SW1 may be disposed between the first conductive portion 510 and the wireless communication module 192. The first switch SW1 may be electrically connected to the first feeding point F1 of the first conductive portion 510 through the first signal path S1. The first switch SW1 may be electrically connected to the wireless communication module 192 through a (1-1)th signal path 511 and a (1-2)th signal path 512. The first switch SW1 may selectively provide, to the first conductive portion 510 (e.g., the first antenna A1), a signal (e.g., a legacy wireless frequency signal) in the first frequency band or a signal (e.g., a satellite wireless frequency signal) in the second frequency band transferred through the wireless communication module 192.

According to an embodiment, the second conductive portion 520 may be disposed between the second non-conductive portion 502 and the third non-conductive portion 503. For example, the second non-conductive portion 502 may be disposed closer to the first non-conductive portion 501 or the hinge module 320 than to the third non-conductive portion 503. The second conductive portion 520 may be electrically connected to the wireless communication module 192. For example, the second conductive portion 520 may be electrically connected to the wireless communication module 192 through a second feeding point F2 and a second signal path S2. The second conductive portion 520 may function as a radiator of the second antenna A2. For example, the second antenna A2 may include the second conductive portion 520. For example, the wireless communication module 192 may be electrically connected to the second feeding point F2 by using a conductive member (e.g., a contact pad, a coupling member, a C-clip, or conductive foam spring). For example, the second antenna A2 (e.g., the second conductive portion 520) may operate in a first frequency band (e.g., a legacy frequency band) or a second frequency band (e.g., a satellite frequency band). For example, the first frequency band may include frequency bands of about 650 MHz to 5 GHz. For example, the second frequency band may include frequency bands of about 1.5 GHz to 1.7 GHz. For example, the second antenna A2 (e.g., the second conductive portion 520) may operate as a legacy antenna or a satellite antenna. For example, the second conductive portion 520 may receive a wireless frequency signal. For example, the second conductive portion 520 may operate to radiate signals in the first frequency band or signals in the second frequency band. For example, the second antenna A2 may operate in a frequency band substantially identical to or different from that of the first antenna A1.

According to an embodiment, a second switch SW2 may be disposed between the second conductive portion 520 and the wireless communication module 192. The second switch SW2 may be electrically connected to the second feeding point F2 of the second conductive portion 520 through the second signal path S2. The second switch SW2 may be electrically connected to the wireless communication module 192 through a (2-1)th signal path 521 and a (2-2)th signal path 522. The second switch SW2 may selectively provide, to the second conductive portion 520, a signal (e.g., a legacy wireless frequency signal) in the first frequency band or a signal (e.g., a satellite wireless frequency signal) in the second frequency band transferred through the wireless communication module 192.

According to an embodiment, the third conductive portion 530 may be disposed between the first non-conductive portion 501 and the second non-conductive portion 502. For example, the first non-conductive portion 501 may be disposed closer to the hinge module 320 than to the second non-conductive portion 502. The third conductive portion 530 may be electrically connected to the wireless communication module 192. For example, the third conductive portion 530 may be electrically connected to the wireless communication module 192 through a third feeding point F3 and a third signal path S3. The third conductive portion 530 may function as a radiator of the third antenna A3. For example, the third antenna A3 may include the third conductive portion 530. For example, the wireless communication module 192 may be electrically connected to the third feeding point F3 by using a conductive member (e.g., a contact pad, a coupling member, a C-clip, or conductive foam spring). In an embodiment, the third antenna A3 (e.g., the third conductive portion 530) may operate in the first frequency band (e.g., a legacy frequency band). For example, the first frequency band may include frequency bands of about 650 MHz to 5 GHz. For example, the third antenna A3 (e.g., the third conductive portion 530) may operate as a legacy antenna.

According to an embodiment, in case that the first antenna A1 (e.g., the first conductive portion 510) and the second antenna A2 (e.g., the second conductive portion 520) operate as satellite antennas, and the third antenna A3 (e.g., the third conductive portion 530) disposed between the first antenna A1 and the second antenna A2 operates as a legacy antenna, the interference between the first antenna A1 and the second antenna A2 may be reduced, or deterioration in the radiation performance of the first antenna A1 and the second antenna A2 may be reduced. For example, in case that the first antenna A1 (e.g., the first conductive portion 510) and the second antenna A2 (e.g., the second conductive portion 520) operate as satellite antennas, and the third antenna A3 (e.g., the third conductive portion 530) disposed between the first antenna A1 and the second antenna A2 operates as a legacy antenna, the first antenna A1 and the second antenna A2 may operate in an optimal state.

According to an embodiment, the third conductive portion 530 may be electrically connected to a first matching circuit M1 through a first point P1. The first matching circuit M1 may be electrically connected to the processor 120 through a first electrical path 531. For example, the first point P1 may be located closer to the first non-conductive portion 501 than to the third feeding point F3.

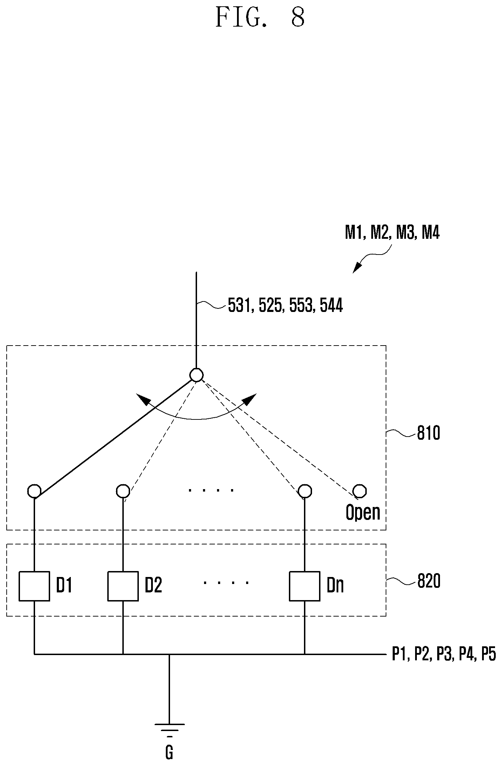

According to an embodiment, the first matching circuit M1 may be disposed between the third conductive portion 530 and the ground G. The first matching circuit M1 may be electrically connected to the processor 120 through a first electrical path 531. The first matching circuit M1 may operate according to control of the processor 120. The first matching circuit M1 may be electrically connected to the first point P1 of the third conductive portion 530 and control an electrical characteristic of the third conductive portion 530. For example, the first matching circuit M1 may control parasitic resonance and a current flow of the third conductive portion 530. The first matching circuit M1 may be electrically connected to the ground G. In an embodiment, the first matching circuit M1 may include at least one switch (e.g., the switch 810 in FIG. 8) and/or at least one lumped element (e.g., the lumped element 820 in FIG. 8) (e.g., a capacitor and/or inductor). For example, the first matching circuit M1 may change the connection of the third conductive portion 530 and the ground G by using the at least one switch and the at least one lumped element. For example, according to control of the processor 120, the first matching circuit M1 may be configured to electrically connect or electrically disconnect the third conductive portion 530 and the ground G. For example, the processor 120 may control an impedance of the first matching circuit M1 to correspond to a first impedance or a second impedance.

According to an embodiment, in case that the first conductive portion 510 operates to radiate signals in the first frequency band (e.g., about 650 MHz to 5 GHz) or signals in the second frequency band (e.g., about 1.5 GHz to 1.7 GHz), matching of the first matching circuit M1 may be controlled (e.g., adjusted) according to control of the processor 120 to generate resonance in the first frequency band (e.g., about 650 MHz to 5 GHz) or the second frequency band (e.g., about 1.5 GHz to 1.7 GHz). For example, the first matching circuit M1 may control (e.g., adjust) an impedance of the third antenna A3 including the third conductive portion 530, based on control of the processor 120 and/or instructions stored in the memory 130. For example, in case that the first conductive portion 510 (e.g., the first antenna Al) and/or the second conductive portion 520 (e.g., the second antenna A2) operates as a satellite antenna (e.g., the second frequency band), the first matching circuit M1 may improve radiation performance, directivity and/or an upper hemisphere radiation pattern of the first antenna A1 and/or the second antenna A2.

According to an embodiment, the second matching circuit M2 may be disposed between the second conductive portion 520 and the ground G. The second matching circuit M2 may be electrically connected to the processor 120 through a second electrical path 525. The second matching circuit M2 may operate according to control of the processor 120. The second matching circuit M2 may be electrically connected to the second point P2 of the second conductive portion 520 and control an electrical characteristic of the second conductive portion 520. For example, the second matching circuit M2 may control parasitic resonance and a current flow of the second conductive portion 520. The second matching circuit M2 may be electrically connected to the ground G. In an embodiment, the second matching circuit M2 may include at least one switch (e.g., the switch 810 in FIG. 8) and at least one lumped element (e.g., the lumped element 820 in FIG. 8) (e.g., a capacitor and/or inductor). For example, the second matching circuit M2 may change the connection of the second conductive portion 520 and the ground G by using the at least one switch and the at least one lumped element. For example, according to control of the processor 120, the second matching circuit M2 may be configured to electrically connect or electrically disconnect the second conductive portion 520 and the ground G. For example, the processor 120 may control an impedance of the second matching circuit M2 to correspond to a third impedance or a fourth impedance.

According to an embodiment, in case that the second conductive portion 520 operates to radiate signals in the first frequency band (e.g., about 650 MHz to 5 GHz) or signals in the second frequency band (e.g., about 1.5 GHz to 1.7 GHz), matching of the second matching circuit M2 may be adjusted according to control of the processor 120 to generate resonance in the first frequency band (e.g., about 650 MHz to 5 GHz, or a legacy antenna) or the second frequency band (e.g., about 1.5 GHz to 1.7 GHz, or a satellite antenna). For example, the second matching circuit M2 may be electrically connected to the ground G (e.g., a grounding portion) of the printed circuit board 270. For example, the second matching circuit M2 may control (e.g., adjust) an impedance of the second antenna A2 including the second conductive portion 520, based on control of the processor 120 and/or instructions stored in the memory 130.

According to an embodiment, the processor 120 may control the wireless communication module 192 to transfer a feeding signal to at least one of the first feeding point F1 of the first conductive portion 510, the second feeding point F2 of the second conductive portion 520, and the third feeding point F3 of the third conductive portion 530. The processor 120 may control the first matching circuit M1 to control an electrical length or path of the third conductive portion 530 (e.g., the third antenna A3). The processor 120 may control or adjust an impedance of the first matching circuit M1. The processor 120 may control the second matching circuit M2 to control an electrical length or path of the second conductive portion 520 (e.g., the second antenna A2). The processor 120 may control or adjust an impedance of the second matching circuit M2.

According to an embodiment, while the first conductive portion 510 operates to radiate signals in a first frequency band (e.g., a frequency band of a legacy antenna) and the second conductive portion 520 operates to radiate signals in the first frequency band (e.g., the frequency band of the legacy antenna), the processor 120 may control an impedance of the first matching circuit M1 connected to the third conductive portion 530 to correspond to the first impedance. According to various embodiments, while the first conductive portion 510 operates to radiate signals in a second frequency band (e.g., a frequency band of a satellite antenna) and the second conductive portion 520 operates to radiate signals in the second frequency band (e.g., the frequency band of the satellite antenna), the processor 120 may control an impedance of the first matching circuit M1 connected to the third conductive portion 530 to correspond to the second impedance.

According to an embodiment, in case that the second conductive portion 520 operates to radiate signals in the first frequency band (e.g., a frequency band of a legacy antenna), the processor 120 may control an impedance of the second matching circuit M2 to correspond to a third impedance. According to various embodiments, in case that the second conductive portion 520 operates to radiate signals in the second frequency band (e.g., a frequency band of a satellite antenna), the processor 120 may control an impedance of the second matching circuit M2 to correspond to a fourth impedance.

According to an embodiment, the second lateral member 223 of the second housing 220 may include a fourth non-conductive portion 504 (e.g., a fourth segment), a fifth non-conductive portion 505 (e.g., a fifth segment), a sixth non-conductive portion 506 (e.g., a sixth segment), a fourth conductive portion 540, a fifth conductive portion 550, and/or a sixth conductive portion 560. For example, the fourth non-conductive portion 504, the fifth non-conductive portion 505, and/or the sixth non-conductive portion 506 may be disposed on the second lateral member 223 of the second housing 220. For example, the fourth non-conductive portion 504 and the fifth non-conductive portion 505 may be disposed in an upper direction (e.g., the y-axis direction) of the second lateral member 223. The sixth non-conductive portion 506 may be disposed in the -x-axis direction of the second lateral member 223. For example, the fourth non-conductive portion 504 may be disposed closer to the hinge module 320 than to the fifth non-conductive portion 505 and the sixth non-conductive portion 506.

According to an embodiment, the fourth conductive portion 540 may be disposed between the fourth non-conductive portion 504 and the hinge module 320. The fifth conductive portion 550 may be located between the fifth non-conductive portion 505 and the sixth non-conductive portion 506. The sixth conductive portion 560 may be located between the fourth non-conductive portion 504 and the fifth non-conductive portion 505.

According to an embodiment, a third point P3 of the fifth conductive portion 550 may be electrically connected to the third matching circuit M3. For example, the third matching circuit M3 may be electrically connected to the processor 120 through a third electrical path 553. In an embodiment, the third matching circuit M3 may be disposed between the fifth conductive portion 550 and the ground G. The third matching circuit M3 may operate according to control of the processor 120. The third matching circuit M3 may be electrically connected to the third point P3 of the fifth conductive portion 550 and control an electrical characteristic of the fifth conductive portion 550. For example, the third matching circuit M3 may control parasitic resonance and a current flow of the fifth conductive portion 550. The third matching circuit M3 may be electrically connected to the ground G. In an embodiment, the third matching circuit M3 may include at least one switch (e.g., the switch 810 in FIG. 8) and/or at least one lumped element (e.g., the lumped element 820 in FIG. 8) (e.g., a capacitor and/or inductor). For example, the third matching circuit M3 may change the connection between the fifth conductive portion 550 and the ground G by using the at least one switch and the at least one lumped element. For example, according to control of the processor 120, the third matching circuit M3 may be configured to electrically connect or electrically disconnect the fifth conductive portion 550 and the ground G.

According to an embodiment, in case that the second conductive portion 520 operates to radiate signals in the first frequency band (e.g., about 650 MHz to 5 GHz, or a frequency bane of a legacy antenna) or signals in the second frequency band (e.g., about 1.5 GHz to 1.7 GHz, or a frequency bane of a satellite antenna), the processor 120 may control (adjust) an impedance of the third matching circuit M3 and suppress a current flowing through the fifth conductive portion 550. For example, in case that the second conductive portion 520 operates in the second frequency band (e.g., about 1.5 GHz to 1.7 GHz) (e.g., operates as a satellite antenna) in a folding state of the first housing 210 and the second housing 220, the processor 120 may control (adjust) an impedance of the third matching circuit M3 and suppress a current flowing through the fifth conductive portion 550 to reduce deterioration of the radiation performance of the second antenna A2 including the second conductive portion 520.

According to an embodiment, the fourth conductive portion 540 and the sixth conductive portion 560 may be electrically connected to the fourth matching circuit M4. For example, the fourth matching circuit M4 may be electrically connected to the processor 120 through a fourth electrical path 544. The fourth conductive portion 540 may be electrically connected to the fourth matching circuit M4 at the fourth point P4. The sixth conductive portion 560 may be electrically connected to the fourth matching circuit M4 at the fifth point P5. The fourth matching circuit M4 may be disposed between the fourth conductive portion 540 and the sixth conductive portion 560, and the ground G. The fourth matching circuit M4 may operate according to control of the processor 120. The fourth matching circuit M4 may control an electrical characteristic of the fourth conductive portion 540 and the sixth conductive portion 560. For example, the fourth matching circuit M4 may control parasitic resonance and a current flow of the fifth conductive portion 540 and the sixth conductive portion 560. The fourth matching circuit M4 may be electrically connected to the ground G. In an embodiment, the fourth matching circuit M4 may include at least one switch (e.g., the switch 810 in FIG. 8) and/or at least one lumped element (e.g., the lumped element 820 in FIG. 8) (e.g., a capacitor and/or inductor). For example, the fourth matching circuit M4 may change the electrical connection between the fourth conductive portion 540 and/or the sixth conductive portion 560 and the ground G by using the at least one switch and the at least one lumped element. For example, according to control of the processor 120, the fourth matching circuit M4 may be configured to electrically connect or electrically disconnect the fourth conductive portion 540 and the sixth conductive portion 560 to or from the ground G.

According to an embodiment, in case that the first conductive portion 510 operates to radiate signals in the first frequency band (e.g., about 650 MHz to 5 GHz) or signals in the second frequency band (e.g., about 1.5 GHz to 1.7 GHz), the processor 120 may control (adjust) an impedance of the fourth matching circuit M4 and suppress a current flowing through the fourth conductive portion 540 and the sixth conductive portion 560. For example, in case that the first conductive portion 510 operates in the second frequency band (e.g., about 1.5 GHz to 1.7 GHz) (e.g., operates as a satellite antenna) in the folding state of the first housing 210 and the second housing 220, the processor 120 may control (adjust) an impedance of the fourth matching circuit M4 and suppress a current flowing through the fourth conductive portion 540 and the sixth conductive portion 560 to reduce deterioration of the radiation performance of the first antenna A1 including the first conductive portion 510.

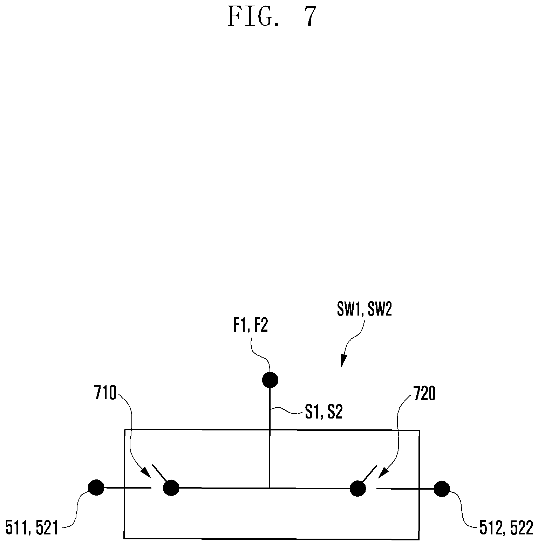

FIG. 7 is a diagram schematically illustrating a configuration of a first switch or a second switch of the foldable electronic device shown in FIG. 6 according to an embodiment of the disclosure.

According to an embodiment, the first switch SW1 shown in FIG. 6 may selectively provide, to the first feeding point F1 of the first conductive portion 510, a signal (e.g., a legacy wireless frequency signal) in the first frequency band or a signal (e.g., a satellite wireless frequency signal) in the second frequency band transferred through the (1-1)th signal path 511 or the (1-2)th signal path 512 electrically connected to the wireless communication module 192.

According to an embodiment, in case that a signal in the first frequency band is transferred to the first feeding point F1, with respect to the first switch SW1, a first contact point 710 may be turned on and a second contact point 720 may be turned off. For example, in case that a signal in the second frequency band is transferred to the first feeding point F1, with respect to the first switch SW1, the second contact point 720 may be turned on and the first contact point 710 may be turned off.

According to an embodiment, the second switch SW2 shown in FIG. 6 may selectively provide, to the second feeding point F2 of the second conductive portion 520, a signal (e.g., a legacy wireless frequency signal) in the first frequency band or a signal (e.g., a satellite wireless frequency signal) in the second frequency band transferred through the (2-1)th signal path 521 or the (2-2)th signal path 522 electrically connected to the wireless communication module 192.

According to an embodiment, in case that a signal in the first frequency band is transferred to the second feeding point F2, with respect to the second switch SW2, a first contact point 710 may be turned on and a second contact point 720 may be turned off. For example, in case that a signal in the second frequency band is transferred to the second feeding point F2, with respect to the second switch SW2, the second contact point 720 may be turned on and the first contact point 710 may be turned off.

FIG. 8 is a diagram schematically illustrating a configuration of first to fourth matching circuits of the foldable electronic device shown in FIG. 6 according to an embodiment of the disclosure.

According to an embodiment, the first matching circuit M1, the second matching circuit M2, the third matching circuit M3, or the fourth matching circuit M4 shown in FIG. 6 may include at least one switch 810 and/or at least one lumped element 820 D1, D2, Dn, or Open. For example, the first matching circuit M1, the second matching circuit M2, the third matching circuit M3, or the fourth matching circuit M4 may be electrically connected to the processor 120 through the first electrical path 531, the second electrical path 525, the third electrical path 553, or the fourth electrical path 544 shown in FIG. 6. For example, the at least one lumped element 820 (e.g., a passive element) may have a different element value. For example, the at least one lumped element 820 may include a capacitor having various capacitance values and/or an inductor having various inductance values. The at least one switch 810 may selectively connect an element having an element value (e.g., a matching value) designated according to control of the processor 120 to the first electrical path 531, the second electrical path 525, the third electrical path 553, and/or the fourth electrical path 544. In an embodiment, the at least one switch 810 may include a micro-electromechanical systems (MEMS) switch. The MEMS switch performs a mechanical switching operation using an internal metal plate, providing complete turn on/off characteristics, which may not substantially affect a radiation characteristic of an antenna. In some embodiments, the at least one switch 810 may include a switch including a single pole single throw (SPST), a single pole double throw (SPDT), or three or more throws.

In an embodiment, referring to FIGS. 6 and 8, the first matching circuit M1 may be electrically connected to the first point P1 of the third conductive portion 530. The first matching circuit M1 may be electrically connected to the processor 120 through a first electrical path 531. The first matching circuit M1 may be disposed between the third conductive portion 530 and the ground G. The first point P1 of the third conductive portion 530 may be connected to or disconnected from the ground G through the first matching circuit M1. In an embodiment, the second matching circuit M2 may be electrically connected to the second point P2 of the second conductive portion 520. The second matching circuit M2 may be electrically connected to the processor 120 through a second electrical path 525. The second matching circuit M2 may be disposed between the second conductive portion 520 and the ground G. The second point P2 of the second conductive portion 520 may be connected to or disconnected from the ground G through the second matching circuit M2. In an embodiment, the third matching circuit M3 may be electrically connected to the third point P3 of the fifth conductive portion 550. The third matching circuit M3 may be electrically connected to the processor 120 through the third electrical path 553. The third matching circuit M3 may be disposed between the fifth conductive portion 550 and the ground G. The third point P3 of the fifth conductive portion 550 may be connected to or disconnected from the ground G through the third matching circuit M3. In an embodiment, the fourth matching circuit M4 may be electrically connected to the fourth point P4 of the fourth conductive portion 540 and the fifth point P5 of the sixth conductive portion 560. The fourth matching circuit M4 may be electrically connected to the processor 120 through the fourth electrical path 544. The fourth matching circuit M4 may be disposed between the fourth conductive portion 540 and the sixth conductive portion 560, and the ground G.

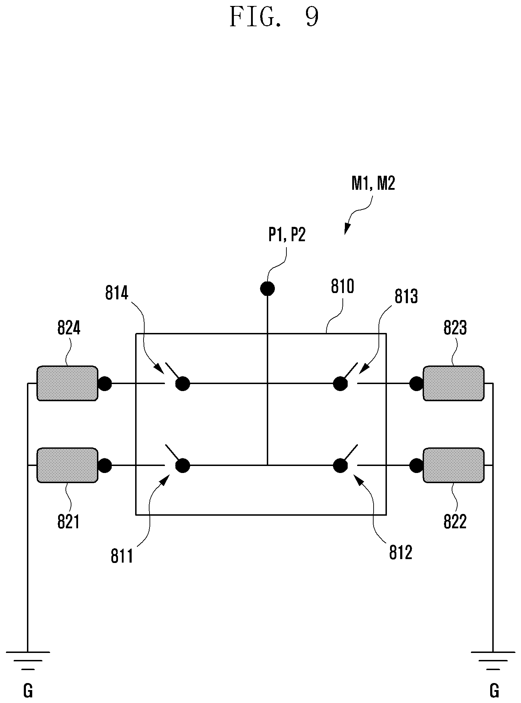

FIG. 9 is a diagram schematically illustrating a configuration of a first matching circuit or a second matching circuit of the foldable electronic device shown in FIG. 6 according to an embodiment of the disclosure.

In an embodiment, in case that the first conductive portion 510 and/or the second conductive portion 520 operates as a legacy antenna in the first frequency band (e.g., about 650 MHz to 5 GHz) or a satellite antenna in the second frequency band (e.g., about 1.5 GHz to 1.7 GHz), connection of the lumped elements 821, 822, 823, and 824 and a contact point 811, 812, 813, or 814 of the switch 810 of the first matching circuit M1 or the second matching circuit M2 may be changed.

According to an embodiment, in case that the first conductive portion 510 and/or the second conductive portion 520 is used as a legacy antenna operating in the first frequency band (e.g., about 650 MHz to 5 GHz), for example, a first contact point 811, a second contact point 812, and/or a third contact point 813 of the switch 810 of the first matching circuit M1 may be turned on, and the third conductive portion 530 may be electrically connected to the ground G through a first lumped element 821, a second lumped element 822, and/or a third lumped element 823. According to various embodiments, in case that the first conductive portion 510 and/or the second conductive portion 520 is used as a satellite antenna operating in the second frequency band (e.g., about 1.5 GHz to 1.7 GHz), a fourth contact point 814 of the switch 810 of the first matching circuit M1 may be turned on, and the first conductive portion 510 and/or the second conductive portion 520 may be electrically connected to the ground G through a fourth lumped element 824.

According to an embodiment, in case that the first conductive portion 510 operates to radiate signals in the first frequency band (e.g., a frequency band of a legacy antenna) and the second conductive portion 520 operates to radiate signals in the first frequency band (e.g., the frequency band of the legacy antenna), the processor 120 may turn on the first contact point 811, the second contact point 812, and/or the third contact point 813 of the switch 810 of the first matching circuit M1 connected to the third conductive portion 530, and cause the third conductive portion 530 to be connected to the ground G through the first lumped element 821, the second lumped element 822, and/or the third lumped element 823, so as to control an impedance of the first matching circuit M1 to correspond to the first impedance.

According to an embodiment, in case that the first conductive portion 510 operates to radiate signals in the second frequency band (e.g., a frequency band of a satellite antenna) and the second conductive portion 520 operates to radiate signals in the second frequency band (e.g., the frequency band of the satellite antenna), the processor 120 may turn on the fourth contact point 814 of the switch 810 of the first matching circuit M1 connected to the third conductive portion 530, and cause the first conductive portion 510 and/or the second conductive portion 520 to be connected to the ground G through the fourth lumped element 824, so as to control an impedance of the first matching circuit M1 to correspond to the second impedance.

According to an embodiment, in case that the second conductive portion 520 operates to radiate signals in the first frequency band (e.g., a frequency band of a legacy antenna), the processor 120 may turn on the first contact point 811, the second contact point 812, and/or the third contact point 813 of the switch 810 of the second matching circuit M2 connected to the second conductive portion 520, and cause the second conductive portion 520 to be connected to the ground G through the first lumped element 821, the second lumped element 822, and/or the third lumped element 823, so as to control an impedance of the second matching circuit M2 to correspond to the third impedance.

According to an embodiment, in case that the second conductive portion 520 operates to radiate signals in the second frequency band (e.g., a frequency band of a satellite antenna), the processor 120 may turn on the fourth contact point 814 of the switch 810 of the second matching circuit M2 connected to the second conductive portion 520, and cause the first conductive portion 510 and/or the third conductive portion 530 to be connected to the ground G through the fourth lumped element 824, so as to control an impedance of the second matching circuit M2 to correspond to the fourth impedance.

According to various embodiments, in case that the first conductive portion 510 and/or the second conductive portion 520 is used as a legacy antenna and/or a satellite antenna, the first contact point 811, the second contact point 812, the third contact point 813, and/or the fourth contact point 814 of the switch 810 may be turned on and/or off through various combinations, and the first conductive portion 510 and/or the second conductive portion 520 may be electrically connected to the ground G in various combinations through the first lumped element 821, the second lumped element 822, the third lumped element 823, and/or the fourth lumped element 824. For example, at least one of the first contact point 811, the second contact point 812, the third contact point 813, and the fourth contact point 814 of the switch 810 may be turned on and off according to the communication environment of the foldable electronic device 200, and the first conductive portion 510 and/or the second conductive portion 520 may be selectively connected to the ground G through at least one of the first lumped element 821, the second lumped element 822, the third lumped element 823, and the fourth lumped element 824. For example, according to a legacy communication environment and/or a satellite communication environment of the foldable electronic device 200, various combinations of the first contact point 811, the second contact point 812, the third contact point 813, and/or the fourth contact point 814 of the switch 810, and the first lumped element 821, the second lumped element 822, the third lumped element 823, and the fourth lumped element 824 may be used.

According to an embodiment, the first lumped element 821 may include a first capacitor having a capacity of about 90pF to 110pF. For example, the second lumped element 822 may include a first inductor having a capacity of about 2nH to 3nH. For example, the third lumped element 823 may include a second inductor having a capacity of about 3nH to 4nH. For example, the fourth lumped element 824 may include a second capacitor having a capacity of about 5pF to 6pF. According to various embodiments, without limitation to the capacities described above, the first capacitor, the first inductor, the second inductor, and the second capacitor, various different capacities and various different combinations may be used for the first lumped element 821, the second lumped element 822, the third lumped element 823, and the fourth lumped element 824.

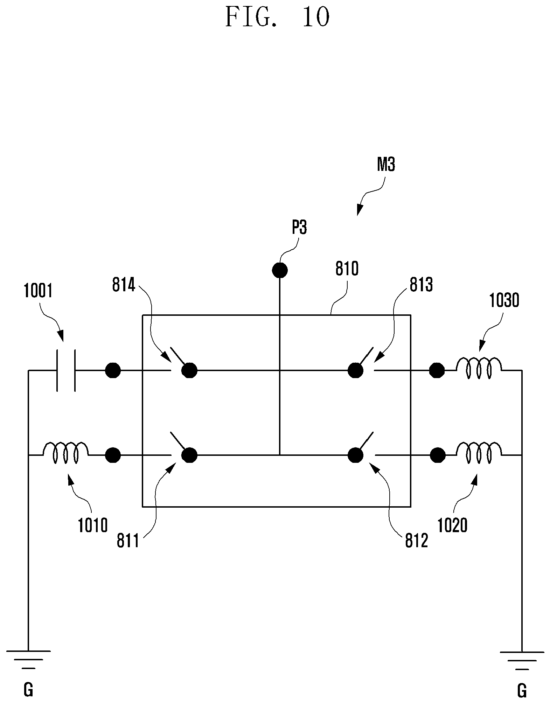

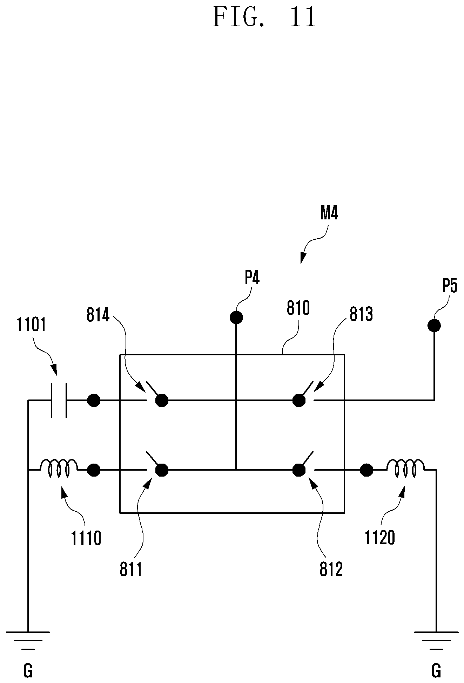

According to various embodiments, the embodiments related to the configuration of the first matching circuit M1 or the second matching circuit M2 shown in FIG. 9 may be identically applied to the third matching circuit M3 shown in FIG. 10 or the fourth matching circuit M4 shown in FIG. 11 below.

FIG. 10 is a diagram schematically illustrating a configuration of a third matching circuit of the foldable electronic device shown in FIG. 6 according to an embodiment of the disclosure. FIG. 11 is a diagram schematically illustrating a configuration of a fourth matching circuit of the foldable electronic device shown in FIG. 6 according to an embodiment of the disclosure.

According to various embodiments, the embodiments related to the configuration of the third matching circuit M3 shown in FIG. 10 or the fourth matching circuit M4 shown in FIG. 11 may be substantially identically applied to the first matching circuit M1 or the second matching circuit M2 shown in FIG. 9.

Referring to FIG. 10, in case that the second conductive portion 520 operates as a legacy antenna in the first frequency band (e.g., about 650 MHz to 5 GHz) or a satellite antenna in the second frequency band (e.g., about 1.5 GHz to 1.7 GHz), connection of the lumped elements 1010, 1020, 1030, and 1001 and the contact point 811, 812, 813, or 814 of the switch 810 of the third matching circuit M3 may be changed. According to an embodiment, the switch 810 may be electrically connected to the third point P3 of the fifth conductive portion 550.

According to an embodiment, in case that the second conductive portion 520 is used as a legacy antenna operating in the first frequency band (e.g., about 650 MHz to 5 GHz), the first contact point 811, the second contact point 812, and/or the third contact point 813 of the switch 810 may be turned on, and the second conductive portion 520 (e.g., the second antenna A2) may be electrically connected to the ground G through the first lumped element 1010 (e.g., the first inductor), the second lumped element 1020 (e.g., the second inductor), and/or the third lumped element 1030 (e.g., the third inductor). According to various embodiments, in case that the second conductive portion 520 is used as a satellite antenna operating in the second frequency band (e.g., about 1.5 GHz to 1.7 GHz), the fourth contact point 814 of the switch 810 may be turned on, and the second conductive portion 520 (e.g., the second antenna A2) may be electrically connected to the ground G through the fourth lumped element 1001 (e.g., the capacitor).

According to an embodiment, the first lumped element 1010 may include a first inductor having a designated capacity. For example, the second lumped element 1020 may include a second inductor having a designated capacity. For example, the third lumped element 1030 may include a third inductor having a designated capacity. For example, the fourth lumped element 1001 may include a capacitor having a designated capacity. According to various embodiments, without limitation to the first inductor, the second inductor, the third inductor, and the capacitor described above, various different combinations may be used for the first lumped element 1010, the second lumped element 1020, the third lumped element 1030, and the fourth lumped element 1001. According to various embodiments, the embodiments related to the configuration of the third matching circuit M3 shown in FIG. 10 may be identically applied to the first matching circuit M1 or the second matching circuit M2 shown in FIG. 9.

Referring to FIG. 11, in case that the first conductive portion 510 operates as a legacy antenna in the first frequency band (e.g., about 650 MHz to 5 GHz) or a satellite antenna in the second frequency band (e.g., about 1.5 GHz to 1.7 GHz), connection of the lumped elements 1120, 1030, and 1001 and the contact point 811, 812, 813, or 814 of the switch 810 of the fourth matching circuit M4 may be changed.

According to an embodiment, in case that the first conductive portion 510 is used as a legacy antenna operating in the first frequency band (e.g., about 650 MHz to 5 GHz), the first contact point 811, the second contact point 812, and/or the third contact point 813 of the switch 810 may be turned on, and the fourth point P4 of the fourth conductive portion 540 and/or the fifth point P5 of the sixth conductive portion 560 may be electrically connected to the ground G through the first lumped element 1110 (e.g., the first inductor) and/or the second lumped element 1120 (e.g., the second inductor). According to an embodiment, the third contact point 813 of the switch 810 may be electrically connected to the fourth point P4 of the fourth conductive portion 540 and the fifth point P5 of the sixth conductive portion 560. According to various embodiments, in case that the first conductive portion 510 is used as a satellite antenna operating in the second frequency band (e.g., about 1.5 GHz to 1.7 GHz), the fourth contact point 814 of the switch 810 may be turned on, and the fourth point P4 of the fourth conductive portion 540 and/or the fifth point P5 of the sixth conductive portion 560 may be electrically connected to the ground G through the third lumped element 1101 (e.g., the capacitor).

According to an embodiment, the first lumped element 1110 may include a first inductor having a designated capacity. For example, the second lumped element 1120 may include a second inductor having a designated capacity. For example, the third lumped element 1101 may include a capacitor having a designated capacity. According to various embodiments, without limitation to the first inductor, the second inductor, and the capacitor described above, various different combinations may be used for the first lumped element 1110, the second lumped element 1120, and the third lumped element 1101.

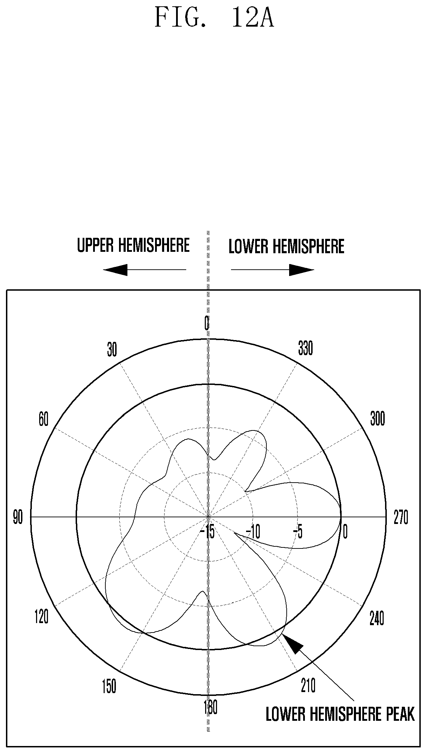

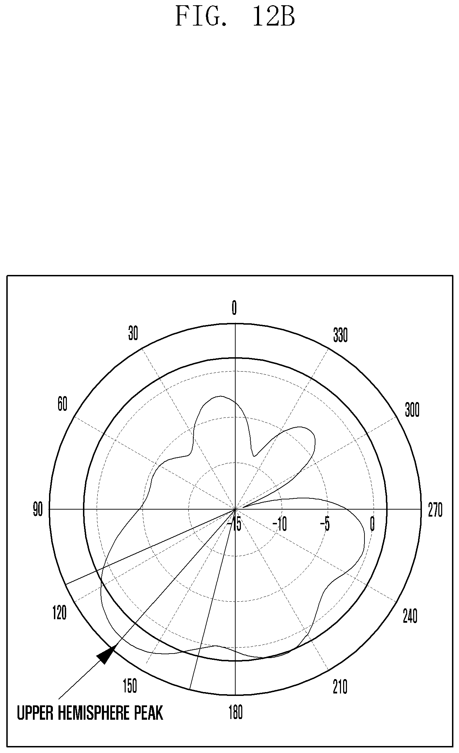

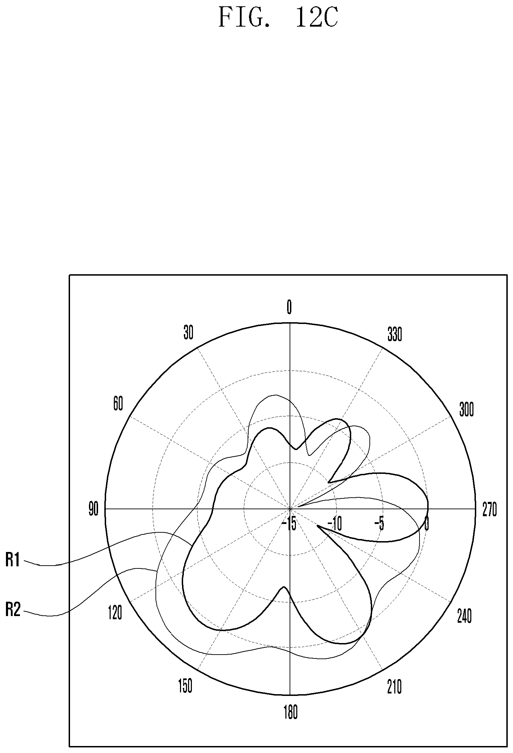

FIG. 12A is a diagram schematically illustrating a radiation pattern in case that a first conductive portion of a foldable electronic device operates as a legacy antenna according to an embodiment of the disclosure. FIG. 12B is a diagram schematically illustrating a radiation pattern in case that a first conductive portion of a foldable electronic device operates as a satellite antenna according to an embodiment of the disclosure. FIG. 12C is a diagram schematically illustrating a change in radiation pattern of a first conductive portion according to a state change of a first matching circuit of a foldable electronic device according to an embodiment of the disclosure.

According to an embodiment, the first conductive portion 510 of the foldable electronic device 200 may operate as a legacy antenna or a satellite antenna depending on a signal in the first frequency band (e.g., a legacy wireless frequency signal) or a signal in the second frequency band (e.g., a satellite wireless frequency signal) transferred through the first switch SW1 and the wireless communication module 192.

According to an embodiment, in case that the first conductive portion 510 is used as a legacy antenna and operates in the first frequency band (e.g., a legacy frequency band), with respect to the first matching circuit M1 (e.g., see FIG. 9) connected to the third conductive portion 530 (e.g., the first point P1), at least one of the first contact point 811, the second contact point 812, and the third contact point 813 of the switch 810 may be turned on, and the third conductive portion 530 may be electrically connected to the ground G through at least one of the first lumped element 821, the second lumped element 822, and the third lumped element 823.

According to an embodiment, in case that the first conductive portion 510 is used as a satellite antenna and operates in the second frequency band (e.g., a satellite frequency band), with respect to the first matching circuit M1 (e.g., see FIG. 9) connected to the third conductive portion 530, the fourth contact point 814 of the switch 810 may be turned on, ,and the third conductive portion 530 may be electrically connected to the ground G through the fourth lumped element 824.

According to an embodiment, the first matching circuit M1 may control (e.g., adjust) an impedance of the first frequency signal (e.g., a legacy wireless frequency signal) transferred to the third conductive portion 530. According to various embodiments, in case that at least one of the first conductive portion 510 and the second conductive portion 520 operates as a satellite antenna, the first matching circuit M1 may improve directivity and/or an upper hemisphere radiation pattern of the foldable electronic device 200.

Referring to FIG. 12A, it may be identified that when the first conductive portion 510 operates in the first frequency band (e.g., a legacy antenna), the foldable electronic device 200 shows a peak between about 190° and 220° in the lower hemisphere.

Referring to FIG. 12B, it may be identified that when the first conductive portion 510 operates in the second frequency band (e.g., a satellite antenna), the foldable electronic device 200 shows a peak between about 110° and 170° in the upper hemisphere.

Referring to FIG. 12C, it may be identified that when the first conductive portion 510 changes from operating in the first frequency band (e.g., a legacy antenna) to operating in a second frequency band (e.g., a satellite antenna), and as the impedance of the first matching circuit M1 is controlled (e.g., adjusted), a first radiation pattern R1 (e.g., see FIG. 12A) is changed to a second radiation pattern R2 (e.g., see FIG. 12B) or directivity is improved.

According to various embodiments, although the aforementioned embodiments illustrate the case in which the first conductive portion 510 operates in the first frequency band (e.g., a legacy antenna) or in the second frequency band (e.g., a satellite antenna), a substantially identical radiation pattern and/or directivity may be applied to the case in which the second conductive portion 520 operates in the first frequency band (e.g., a legacy antenna) or in the second frequency band (e.g., a satellite antenna).

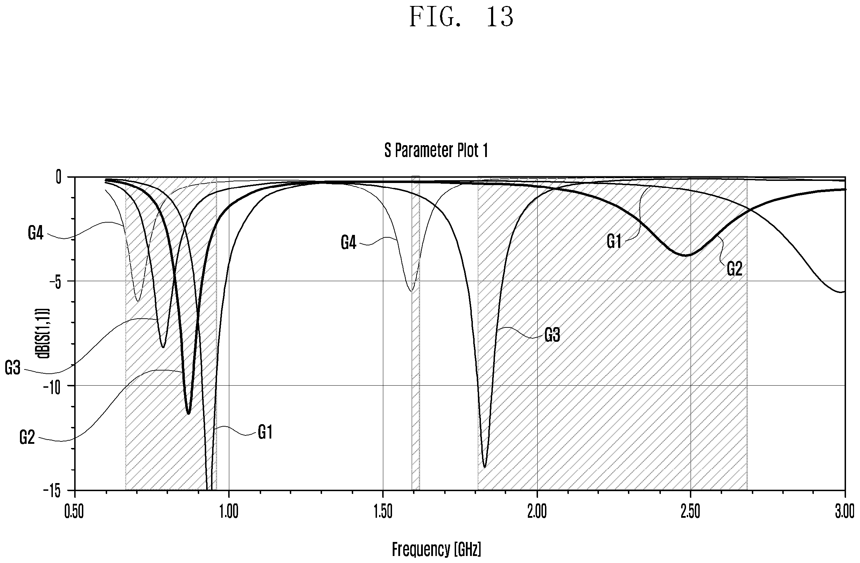

FIG. 13 is a diagram schematically illustrating an antenna characteristic according to a state change of a second matching circuit of a second conductive portion of a foldable electronic device according to an embodiment of the disclosure.

According to an embodiment, the second conductive portion 520 (e.g., the second antenna A2) of the foldable electronic device 200 may operate as a legacy antenna or a satellite antenna depending on a first frequency signal (e.g., a legacy wireless frequency signal) or a second frequency signal (e.g., a satellite wireless frequency signal) transferred through the second switch SW2 and the wireless communication module 192.

According to an embodiment, in case that the second conductive portion 520 is used as a legacy antenna, with respect to the second matching circuit M2 (e.g., see FIG. 9) connected to the second conductive portion 520, the first contact point 811 of the switch 810 may be turned on, and the second conductive portion 520 may be electrically connected to the ground G through the first lumped element 821. In this case, referring to FIG. 13, as shown in a first graph G1, a first resonance frequency G1 may be generated in the first frequency band (e.g., a legacy frequency band) of about 0.9 GHz to 0.95 GHz and about 2 GHz to 2.7 GHz.

According to an embodiment, in case that the second conductive portion 520 is used as a legacy antenna, with respect to the second matching circuit M2 (e.g., see FIG. 9) connected to the second conductive portion 520, the second contact point 812 of the switch 810 may be turned on, and the second conductive portion 520 may be electrically connected to the ground G through the second lumped element 822. In this case, referring to FIG. 13, as shown in a second graph G2, a second resonance frequency G2 may be generated in the first frequency band (e.g., a legacy frequency band) of about 0.8 GHz to 0.9 GHz and about 1.8 GHz to 3 GHz.

According to an embodiment, in case that the second conductive portion 520 is used as a legacy antenna, with respect to the second matching circuit M2 (e.g., see FIG. 9) connected to the second conductive portion 520, the third contact point 813 of the switch 810 may be turned on, and the second conductive portion 520 may be electrically connected to the ground G through the third lumped element 823. In this case, referring to FIG. 13, as shown in a third graph G3, a third resonance frequency G3 may be generated in the first frequency band (e.g., a legacy frequency band) of about 0.7 GHz to 0.8 GHz and about 1.7 GHz to 3 GHz.

According to an embodiment, in case that the second conductive portion 520 is used as a satellite antenna, with respect to the second matching circuit M2 (e.g., see FIG. 9) connected to the second conductive portion 520, the fourth contact point 814 of the switch 810 may be turned on, and the second conductive portion 520 may be electrically connected to the ground G through the fourth lumped element 824. In this case, referring to FIG. 13, as shown in a fourth graph G4, a fourth resonance frequency G4 may be generated in the second frequency band (e.g., a satellite frequency band) of about 0.68 GHz to 0.75 GHz and about 1.5 GHz to 1.7 GHz.

According to various embodiments, in case that the second conductive portion 520 is used as a legacy antenna (e.g., the first frequency band) or a satellite antenna (e.g., the second frequency band), with respect to the second matching circuit M2, at least one of the first contact point 811, the second contact point 812, the third contact point 813, and the fourth contact point 814 of the switch 810 is turned on and/or off and the second conductive portion 520 is electrically connected to the ground through at least one of the first lumped element 821, the second lumped element 822, the third lumped element 823, and the fourth lumped element 824 so that an impedance may be controlled or adjusted.

According to various embodiments, although the aforementioned embodiments illustrate the resonance frequency according to the state change of the second matching circuit M2 in case that the second conductive portion 520 operates in the first frequency band (e.g., a legacy antenna) or in the second frequency band (e.g., a satellite antenna) as an example, the embodiments may be substantially identically applied to a state change of the first matching circuit M1 connected to the third conductive portion 530 in case that the first conductive portion 510 operates in the first frequency band (e.g., a legacy antenna) or in the second frequency band (e.g., a satellite antenna).

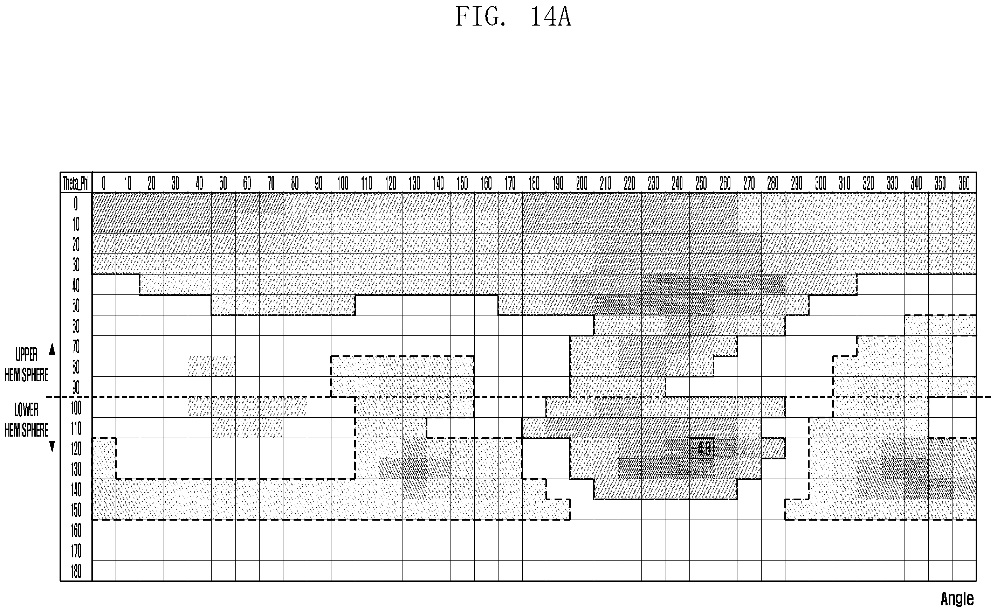

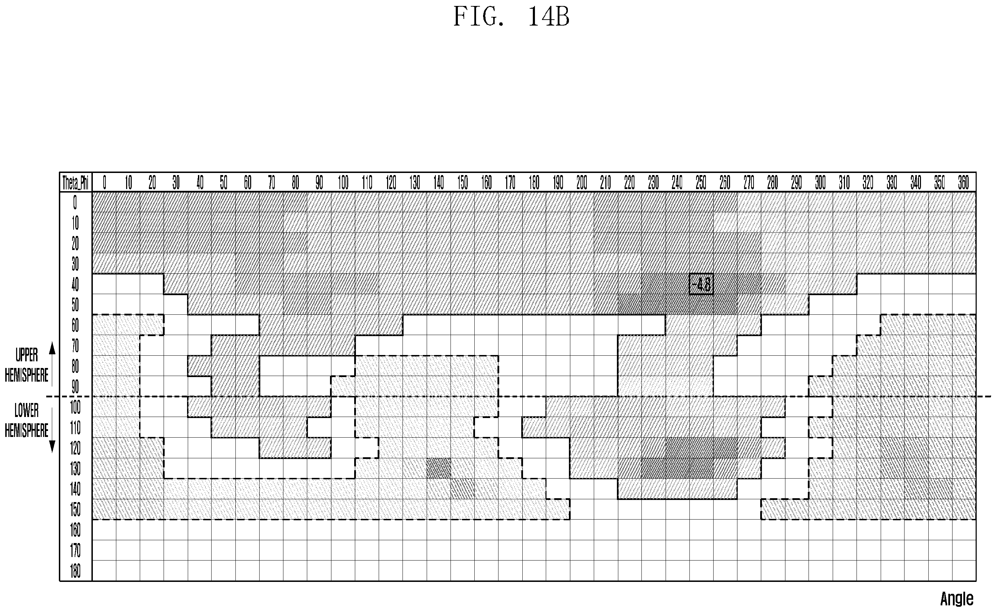

FIG. 14A is a diagram schematically illustrating a radiation pattern according to a state change of a first matching circuit in case that a first conductive portion of a foldable electronic device operates as a legacy antenna according to an embodiment of the disclosure. FIG. 14B is a diagram schematically illustrating a radiation pattern according to a state change of a first matching circuit in case that a first conductive portion of a foldable electronic device operates as a satellite antenna according to an embodiment of the disclosure.

According to an embodiment, the first conductive portion 510 of the foldable electronic device 200 may operate as a legacy antenna or a satellite antenna. For example, in case that the first conductive portion 510 is used as a legacy antenna, with respect to the first matching circuit M1 (e.g., see FIG. 9) connected to the third conductive portion 530, at least one of the first contact point 811, the second contact point 812, and the third contact point 813 of the switch 810 may be turned on, and the third conductive portion 530 may be electrically connected to the ground G through at least one of the first lumped element 821, the second lumped element 822, and the third lumped element 823. For example, in case that the first conductive portion 510 is used as a satellite antenna, with respect to the first matching circuit M1 (e.g., see FIG. 9) connected to the third conductive portion 530, the fourth contact point 814 of the switch 810 may be turned on, and the third conductive portion 530 may be electrically connected to the ground G through the fourth lumped element 824.

Referring to FIG. 14A, it may be identified that when the first conductive portion 510 operates in the first frequency band (e.g., a legacy antenna), an antenna peak point of the first conductive portion 510 is about -4.8 dB in the lower hemisphere.

Referring to FIG. 14B, it may be identified that when the first conductive portion 510 is changed to operate in the second frequency band (e.g., a satellite antenna), an antenna peak point of the first conductive part 510 is changed to an upper hemisphere radiation pattern with a peak gain of about -4.8dB, which is substantially identical to the peak gain in the lower hemisphere.

According to an embodiment, as shown in FIGS. 14A and 14B, it may be identified that when the first conductive portion 510 is changed from operating in the first frequency band (e.g., a legacy antenna) to operating in the second frequency band (e.g., a satellite antenna), the radiation pattern is change from the lower hemisphere to the upper hemisphere while the antenna gain of the first conductive portion 510 is maintained. According to an embodiment, in case that the first conductive portion 510 operates in the second frequency band (e.g., a satellite antenna), due to characteristics of satellite communication, higher antenna gains in the upper hemisphere compared to the lower hemisphere may result in less radiation degradation under gripping conditions for most user electronic devices (e.g., the foldable electronic device 200).

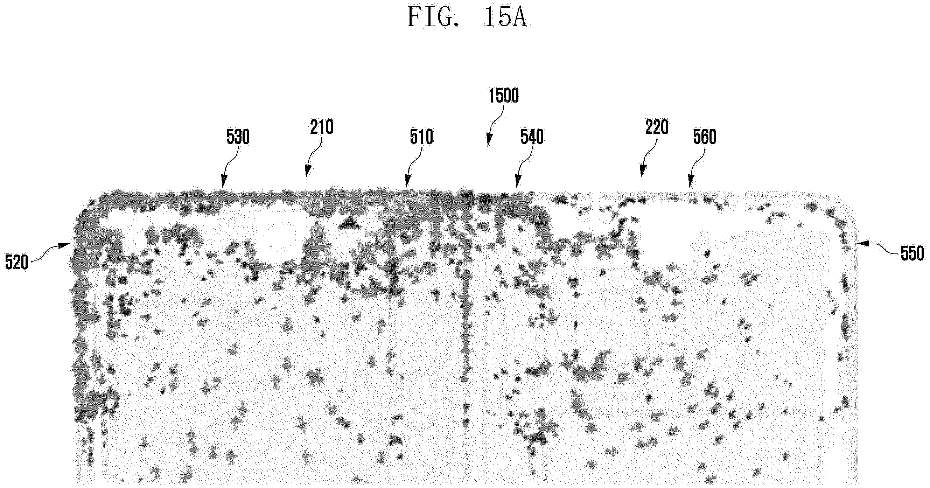

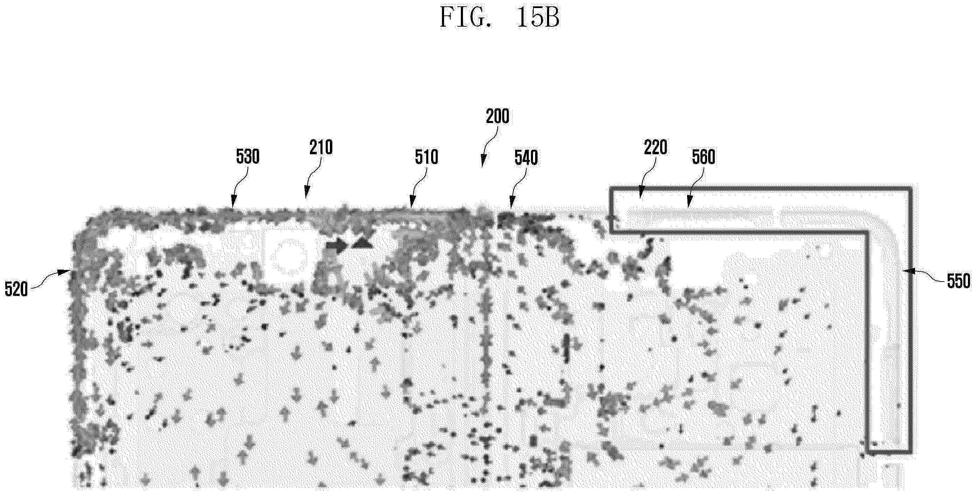

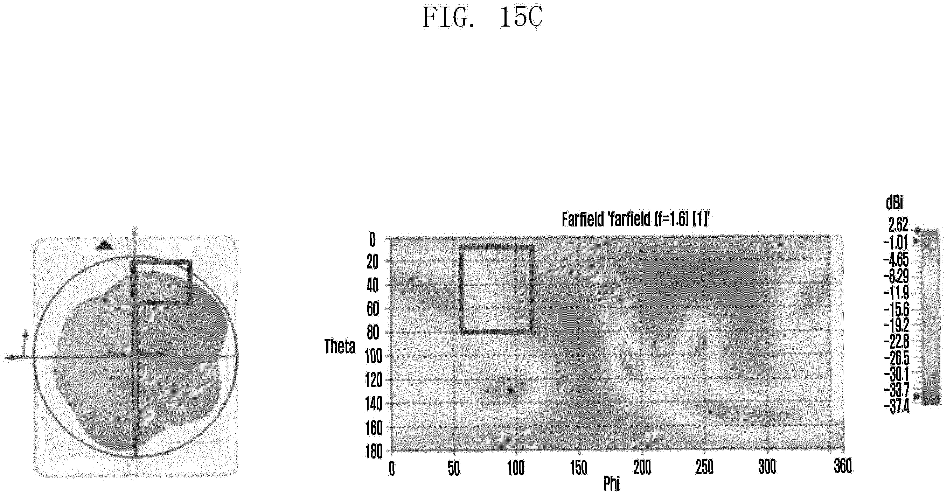

FIG. 15A is a diagram schematically illustrating a current distribution of a foldable electronic device according to a comparative example. FIG. 15B is a diagram schematically illustrating a current distribution of a foldable electronic device according to an embodiment of the disclosure. FIG. 15C is a diagram schematically illustrating a radiation pattern of the foldable electronic device shown in FIG. 15B according to an embodiment of the disclosure.

According to various embodiments, the foldable electronic device 1500 according to the comparative example shown in FIG. 15A may not include at least one of the third matching circuit M3 (e.g., see FIG. 10) and the fourth matching circuit M4 (e.g., see FIG. 11) of the foldable electronic device 200 according to an embodiment of the disclosure. Referring to the comparative example shown in FIG. 15A, it may be identified that when the foldable electronic device 1500 does not include at least one of the third matching circuit M3 and the fourth matching circuit M4 in the second housing 220, a current flows through the fifth conductive portion 550 and the sixth conductive portion 560 of the second housing 220. For example, in case that a current flows through the fifth conductive portion 550, the fourth conductive portion 540, and the sixth conductive portion 560 of the second housing 220 in the folding state of the first housing 210 and the second housing 220, there may be degradation in radiation performance of the second conductive portion 520, the first conductive portion 510, and the third conductive portion 530 of the first housing 210 facing the fifth conductive portion 550, the fourth conductive portion 540, and the sixth conductive portion 560.

According to an embodiment, the foldable electronic device 200 according to an embodiment of the disclosure shown in FIG. 15B may include at least one of the third matching circuit M3 (e.g., see FIGS. 6 and 10) connected to the fifth conductive portion 550 and the fourth matching circuit M4 (e.g., see FIGS. 6 and 10) connected to the fourth conductive portion 540 and the sixth conductive portion 560. Referring to the embodiment shown in FIG. 15B, it may be identified that when the foldable electronic device 200 includes at least one of the third matching circuit M3 and the fourth matching circuit M4 in the second housing 220, a current flowing through at least a portion of the fifth conductive portion 550, the fourth conductive portion 540, and the sixth conductive portion 560 of the second housing 220 is reduced.

According to an embodiment, with respect to the foldable electronic device 200 according to an embodiment of the disclosure shown in FIG. 15B, an impedance of at least one of the third matching circuit M3 and the fourth matching circuit M4 is controlled (e.g., adjusted) according to control of the processor 120 so that a current flowing through the fifth conductive portion 550, the fourth conductive portion 540, and the sixth conductive portion 560 may be reduced. For example, in case that a current flowing through the fifth conductive portion 550, the fourth conductive portion 540, and the sixth conductive portion 560 of the second housing 220 is reduced or suppressed, even when the first housing 210 and the second housing 220 are in the folding state, degradation in radiation performance of the second conductive portion 520, the first conductive portion 510, and the third conductive portion 530 of the first housing 210 facing the fifth conductive portion 550, the fourth conductive portion 540, and the sixth conductive portion 560 may be reduced.

According to an embodiment, as shown in FIG. 15B, it may be identified that when the impedance of at least one of the third matching circuit M3 and the fourth matching circuit M4 is controlled (e.g., adjusted) so that the current flowing through the fifth conductive portion 550, the fourth conductive portion 540, and the sixth conductive portion 560 is reduced, radiation performance and/or directivity in the upper hemisphere (e.gl, the upward direction) of at least one of the first conductive portion 510 (e.g., the first antenna A1) and the second conductive portion 520 (e.g., the second antenna A2) of the foldable electronic device 200 is improved as shown in FIG. 15C.

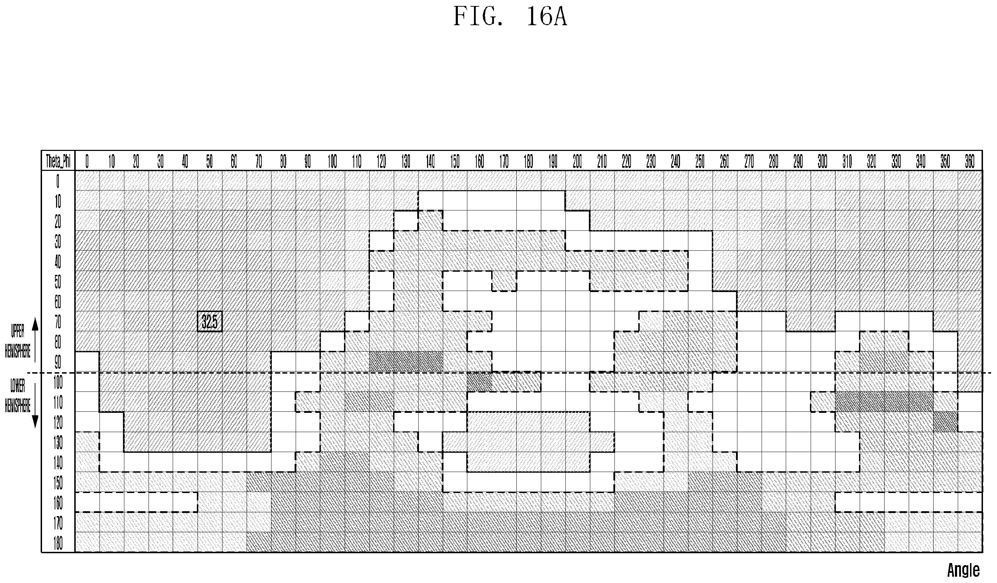

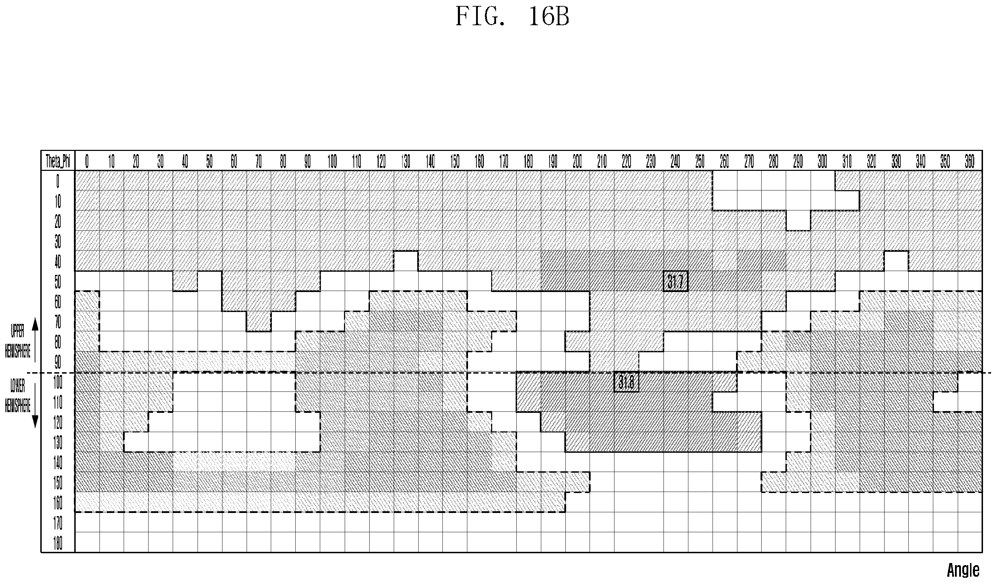

FIG. 16A is a diagram schematically illustrating radiation performance in case that a foldable electronic device is in an unfolding state according to an embodiment of the disclosure. FIG. 16B is a diagram schematically illustrating radiation performance in case that a foldable electronic device is in a folding state according to an embodiment of the disclosure.

According to an embodiment, FIG. 16A may be a diagram schematically illustrating an effective isotropically radiated power (EIRP) when the foldable electronic device 200 according to an embodiment of the disclosure is in the unfolding state. FIG. 16B may be a diagram schematically illustrating an EIRP when the foldable electronic device 200 according to an embodiment of the disclosure is in the folding state.

Referring to FIG. 16A, since a peak gain is generated at about θ70° and φ50° coordinates when the foldable electronic device 200 is in the unfolding state, it may be identified that a peak gain is generated in the upper hemisphere (e.g., an upward direction) of the foldable electronic device 200. For example, it may be identified that when the foldable electronic device 200 is in the unfolding state, an antenna peak point is about 32.5 dB in the upper hemisphere.

Referring to FIG. 16B, it may be identified that when the foldable electronic device 200 is in the folding state, an effective isotropic radiated power (EIRP) of about 31.8dB is generated at coordinates of about θ100° and φ220° in the lower hemisphere, and an EIRP of about 31.7dB is generated at coordinates of about θ50° and φ240° in the upper hemisphere. For example, in case that the foldable electronic device 200 is in the folding state, an identical gain may be generated in the lower hemisphere and the upper hemisphere. In an embodiment, referring to FIG. 16B, it may be identified that a distribution of a radiation pattern in the upper hemisphere has a wider range of a higher effective isotropic radiated power (EIRP) value compared to the lower hemisphere.

According to an embodiment, the case that the distribution of a radiation pattern in the upper hemisphere has a wider range of a higher effective isotropic radiated power (EIRP) value compared to the lower hemisphere when the foldable electronic device 200 is in the folding state may indicate that even if a lower end of the foldable electronic device 200 is gripped by the user, the radiation performance of the first conductive portion 510 and the second conductive portion 520 is not significantly degraded and a satellite communication service is possible.

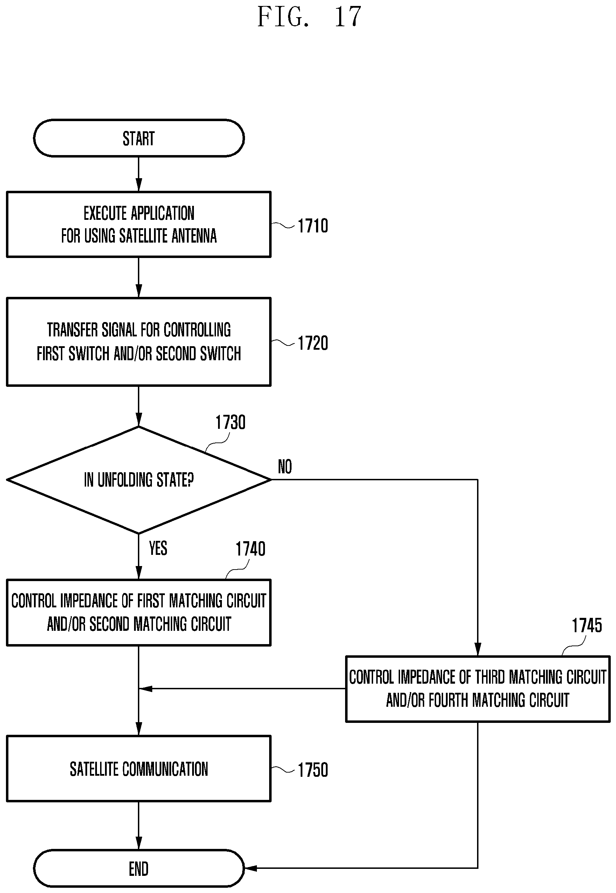

FIG. 17 is a flowchart schematically illustrating an operation of a foldable electronic device according to an embodiment of the disclosure.

According to an embodiment, the foldable electronic device 200 may use a satellite communication service by using at least one of the first antenna A1 including the first conductive portion 510 and the second antenna A2 including the second conductive portion 520 in the unfolding state or the folding state. For example, operations 1710 to 1750 below may be performed by the processor 120 of the foldable electronic device 200 described above. For example, embodiments shown in FIGS. 5 to 16B may be applied to operations in FIG. 17.

In embodiments below, respective operations may be sequentially performed, but are not necessarily sequentially performed. For example, the order of each operation may be changed, or one or more operations may be performed in parallel.

In operation 1710, according to user selection, the processor 120 may execute an application configured to use at least one of the first antenna A1 including the first conductive portion 510 and the second antenna A2 including the second conductive portion 520 of the foldable electronic device 200 as a satellite antenna (e.g., the second frequency band).

In operation 1720, the processor 120 may transfer a signal to control the first switch SW1 and/or the second switch SW2.

In operation 1730, the processor 120 may identify whether the foldable electronic device 200 is in the unfolding state or the folding state through the sensor module (e.g., the sensor module 176 in FIG. 1). For example, the sensor module may include a hall sensor, a 6-axis sensor, an acceleration sensor, and/or an angular velocity sensor.

In case that the foldable electronic device 200 is in the unfolding state, in operation 1740, the processor 120 may control at least one of the first matching circuit M1 and the second matching circuit M2 to control (e.g., adjust) an impedance.

In operation 1745, in case that the foldable electronic device 200 is in the folding state, the processor 120 may control the first matching circuit M1 and/or the second matching circuit M2 of the first housing 210 and the third matching circuit M3 and/or the fourth matching circuit M4 of the second housing 220 to control (e.g., adjust) an impedance.

In operation 1750, in case that the processor 120 controls (e.g., adjusts) an impedance of at least one of the first matching circuit M1, the second matching circuit M2, the third matching circuit M3, and the fourth matching circuit M4, the foldable electronic device 200 may be allowed to perform a satellite communication service.

FIG. 18 is a diagram schematically illustrating a circuit configuration of an electronic device including at least one switch and a matching circuit according to an embodiment of the disclosure. FIG. 19 is a diagram schematically illustrating a circuit configuration of an electronic device including at least one switch and a matching circuit according to various embodiments of the disclosure.

According to various embodiments, the electronic device 1800 described below may include at least a portion of the embodiments of the electronic device 101 shown in FIG. 1 and the foldable electronic device 200 shown in FIGS. 2A to 17. With respect to the description of the electronic device 200 below, identical numerals may be used for substantially identical elements of the embodiments disclosed in FIGS. 1 to 17, and overlapping description with respect to the functions thereof may be omitted. For example, the embodiments shown in FIGS. 2 to 17 may be a description for the foldable electronic device 200 and the embodiments shown in FIGS. 18 and 19 may be a description for the bar type electronic device 1800.

Referring to FIG. 18, the electronic device 1800 may include a housing 1801. The housing 1801 may include a printed circuit board (not shown) (e.g., the printed circuit board 270 in FIG. 5). A wireless communication module 192, a processor 120, and/or a ground G (e.g., a grounding portion) may be included in or disposed on the printed circuit board (not shown).

According to an embodiment, the housing 1801 may include a first non-conductive portion 501 (e.g., a first segment), a second non-conductive portion 502 (e.g., a second segment), a third non-conductive portion 503 (e.g., a third segment), a fourth non-conductive portion (e.g., a fourth segment), a first conductive portion 510, a second conductive portion 520, and/or a third conductive portion 530. For example, the first non-conductive portion 501 (e.g., the first segment) and the second non-conductive portion 502 (e.g., the second segment) may be disposed in an upper direction (e.g., the y-axis direction) of the housing 1801. The third non-conductive portion 503 (e.g., the third segment) may be disposed in the x-axis direction of the housing 1801. The fourth non-conductive portion 504 (e.g., the fourth segment) may be disposed in the -x-axis direction of the housing 1801.

According to an embodiment, the first conductive portion 510 may be disposed between the first non-conductive portion 501 and the fourth non-conductive portion 504. The first conductive portion 510 may be electrically connected to the wireless communication module 192 (e.g., an RFIC). For example, the first conductive portion 510 may be electrically connected to the wireless communication module 192 through a first feeding point F1 and a first signal path S1. The first conductive portion 510 may function as a radiator of the first antenna A1. For example, the first antenna A1 may include the first conductive portion 510. For example, the wireless communication module 192 may be electrically connected to the first feeding point F1 by using a conductive member (e.g., a contact pad, a coupling member, a C-clip, or conductive foam spring). In an embodiment, the first antenna A1 (e.g., the first conductive portion 510) may operate in a first frequency band (e.g., a legacy frequency band) or a second frequency band (e.g., a satellite frequency band). For example, the first frequency band may include frequency bands of about 650 MHz to 5 GHz. For example, the second frequency band may include frequency bands of about 1.5 GHz to 1.7 GHz. For example, the first antenna A1 (e.g., the first conductive portion 510) may operate as a legacy antenna or a satellite antenna. For example, the first conductive portion 510 may transmit and receive a wireless frequency signal. For example, the first conductive portion 510 may operate to radiate signals in the first frequency band or signals in the second frequency band. For example, the first antenna A1 may operate in a frequency band identical to or different from that of the second antenna A2.

According to an embodiment, a first switch SW1 may be disposed between the first conductive portion 510 and the wireless communication module 192. The first switch SW1 may be electrically connected to the first feeding point F1 of the first conductive portion 510 through the first signal path S1. The first switch SW1 may be electrically connected to the wireless communication module 192 through a (1-1)th signal path 511 and a (1-2)th signal path 512. The first switch SW1 may selectively provide, to the first conductive portion 510, a signal (e.g., a legacy wireless frequency signal) in the first frequency band or a signal (e.g., a satellite wireless frequency signal) in the second frequency band transferred through the wireless communication module 192. For example, the first switch SW1 may be configured to be substantially identical to the first switch SW1 shown in FIG. 7.

According to an embodiment, the second conductive portion 520 may be disposed between the second non-conductive portion 502 (e.g., the second segment) and the third non-conductive portion 503 (e.g., the third segment). For example, the second non-conductive portion 502 (e.g., the second segment) may be disposed closer to the first non-conductive portion 501 (e.g., the first segment) than to the third non-conductive portion 503 (e.g., the third segment). The second conductive portion 520 may be electrically connected to the wireless communication module 192. For example, the second conductive portion 520 may be electrically connected to the wireless communication module 192 through a second feeding point F2 and a second signal path S2. The second conductive portion 520 may function as a radiator of the second antenna A2. For example, the second antenna A2 may include the second conductive portion 520. For example, the wireless communication module 192 may be electrically connected to the second feeding point F2 by using a conductive member (e.g., a contact pad, a coupling member, a C-clip, or conductive foam spring). For example, the second antenna A2 (e.g., the second conductive portion 520) may operate in a first frequency band (e.g., a legacy frequency band) or a second frequency band (e.g., a satellite frequency band). For example, the first frequency band may include frequency bands of about 650 MHz to 5 GHz. For example, the second frequency band may include frequency bands of about 1.5 GHz to 1.7 GHz. For example, the second antenna A2 (e.g., the second conductive portion 520) may operate as a legacy antenna or a satellite antenna. For example, the second conductive portion 520 (e.g., the second antenna A2) may receive a wireless frequency signal. For example, the second conductive portion 520 may operate to radiate signals in the first frequency band or signals in the second frequency band. For example, the second antenna A2 may operate in a frequency band identical to or different from that of the first antenna A1.

According to an embodiment, a second switch SW2 may be disposed between the second conductive portion 520 and the wireless communication module 192. The second switch SW2 may be electrically connected to the second feeding point F2 of the second conductive portion 520 through the second signal path S2. The second switch SW2 may be electrically connected to the wireless communication module 192 through a (2-1)th signal path 521 and a (2-2)th signal path 522. The second switch SW2 may selectively provide, to the second conductive portion 520, a signal (e.g., a legacy wireless frequency signal) in the first frequency band or a signal (e.g., a satellite wireless frequency signal) in the second frequency band transferred through the wireless communication module 192. For example, the second switch SW2 may be configured to be substantially identical to the second switch SW2 shown in FIG. 7.

According to an embodiment, the third conductive portion 530 may be disposed between the first non-conductive portion 501 (e.g., the first segment) and the second non-conductive portion 502 (e.g., the second segment). The third conductive portion 530 may be electrically connected to the wireless communication module 192. For example, the third conductive portion 530 may be electrically connected to the wireless communication module 192 through a third feeding point F3 and a third signal path S3. The third conductive portion 530 may function as a radiator of the third antenna A3. For example, the third antenna A3 may include the third conductive portion 530. For example, the wireless communication module 192 may be electrically connected to the third feeding point F3 by using a conductive member (e.g., a contact pad, a coupling member, a C-clip, or conductive foam spring). In an embodiment, the third antenna A3 (e.g., the third conductive portion 530) may operate in the first frequency band (e.g., a legacy frequency band). For example, the first frequency band may include frequency bands of about 650 MHz to 5 GHz. For example, the third antenna A3 (e.g., the third conductive portion 530) may operate as a legacy antenna.

According to an embodiment, in case that the first antenna A1 (e.g., the first conductive portion 510) and the second antenna A2 (e.g., the second conductive portion 520) operate as satellite antennas, and the third antenna A3 (e.g., the third conductive portion 530) disposed between the first antenna A1 and the second antenna A2 operates as a legacy antenna, interference between the first antenna A1 and the second antenna A2 may be reduced.

According to an embodiment, the third conductive portion 530 (e.g., the third antenna A3) may be electrically connected to a matching circuit M through a first point P1. The matching circuit M may be electrically connected to the processor 120 through a first electrical path 531.

According to an embodiment, the matching circuit M (e.g., the first matching circuit M1 in FIG. 6) may be disposed between the third conductive portion 530 and the ground G. The matching circuit M may be electrically connected to the processor 120 through the electrical path 531 (e.g., the first electrical path 531 in FIG. 6). For example, the matching circuit M may operate according to control of the processor 120. The matching circuit M may be electrically connected to the first point P1 of the third conductive portion 530 and control an electrical characteristic of the third conductive portion 530. For example, the matching circuit M may control parasitic resonance and a current flow of the third conductive portion 530. The matching circuit M may be electrically connected to the ground G. In an embodiment, the matching circuit M may include at least one switch (e.g., the switch 810 in FIG. 8) and/or at least one lumped element (e.g., the lumped element 820 in FIG. 8) (e.g., a capacitor and/or inductor). For example, according to control of the processor 120, the matching circuit M may change the connection of the third conductive portion 530 and the ground G by using the at least one switch and the at least one lumped element. For example, the matching circuit M may be configured to electrically connect or electrically disconnect the third conductive portion 530 and the ground G. For example, the matching circuit M may be configured to be substantially identical to the first matching circuit M1 or the second matching circuit M2 shown in FIG. 9.

According to an embodiment, in case that the first antenna A1 including the first conductive portion 510 and/or the second antenna A2 including the second conductive portion 520 operates in the first frequency band (e.g., about 650 MHz to 5 GHz) or in the second frequency band (e.g., about 1.5 GHz to 1.7 GHz), matching of the matching circuit M may be adjusted according to control of the processor 120 to generate resonance in the first frequency band (e.g., about 650 MHz to 5 GHz) or the second frequency band (e.g., about 1.5 GHz to 1.7 GHz). For example, the matching circuit M may control (e.g., adjust) an impedance of the third antenna A3 including the third conductive portion 530 through the wireless communication module 192. For example, in case that the first conductive portion 510 and/or the second conductive portion 520 operates as a satellite antenna (e.g., the second frequency band), the matching circuit M may improve radiation performance, directivity and/or an upper hemisphere radiation pattern of the first antenna A1 and/or the second antenna A2.

According to an embodiment, the processor 120 may control the wireless communication module 192 to transfer a feeding signal to at least one of the first feeding point F1 of the first conductive portion 510, the second feeding point F2 of the second conductive portion 520, and the third feeding point F3 of the third conductive portion 530. The processor 120 may control the matching circuit M to control an electrical length or path of the third antenna A3 including the third conductive portion 530. The processor 120 may control (e.g., adjust) an impedance of the matching circuit M.

According to an embodiment, while the first conductive portion 510 operates to radiate signals in a first frequency band (e.g., a frequency band of a legacy antenna) and the second conductive portion 520 operates to radiate signals in the first frequency band (e.g., the frequency band of the legacy antenna), the processor 120 may control an impedance of the matching circuit M connected to the third conductive portion 530 to correspond to the first impedance. According to various embodiments, while the first conductive portion 510 operates to radiate signals in a second frequency band (e.g., a frequency band of a satellite antenna) and the second conductive portion 520 operates to radiate signals in the second frequency band (e.g., the frequency band of the satellite antenna), the processor 120 may control an impedance of the matching circuit M connected to the third conductive portion 530 to correspond to the second impedance.

According to an embodiment, the matching circuit M may be configured to be substantially identical to the first switch M1 shown in FIG. 9.

According to an embodiment, the matching circuit M may include a switch 810 including at least one of a first contact point 811, a second contact point 812, a third contact point 813, and a fourth contact point 814. The matching circuit M may include at least one of a first lumped element 821, a second lumped element 822, a third lumped element 823, and a fourth lumped element 824.

According to an embodiment, in case that the matching circuit M is controlled by the processor 120 to correspond to the first impedance, in the matching circuit M, at least one of the first contact point 811, the second contact point 812, and the third contact point 813 may be turned on, and the third conductive portion 530 may be electrically connected to the ground G through at least one of the first lumped element 821, the second lumped element 822, and the third lumped element 823.

According to an embodiment, in case that the matching circuit M is controlled by the processor 120 to correspond to the second impedance, in the matching circuit M, the fourth contact point 814 may be turned on, and the third conductive portion 530 may be electrically connected to the ground G through the fourth lumped element 824.

According to an embodiment, the first antenna A1 including the first conductive portion 510 may operate as a legacy antenna or satellite antenna, the second antenna A2 including the second conductive portion 520 may operate as a legacy antenna or satellite antenna, and the third antenna A3 including the third conductive portion 530 may operate as a legacy antenna.

According to various embodiments, FIG. 19 may differ in only some configurations relative to the electronic device 1800 shown in FIG. 18 above, while other configurations may be substantially the same. For example, in the electronic device 1800 shown in FIG. 19, the first non-conductive portion 501 (e.g., the first segment) may be disposed in the -x-axis direction of the housing 1801, the second non-conductive portion 502 (e.g., the second segment) may be disposed in the upward direction (e.g., the y-axis direction) of the housing 1801, and the third non-conductive portion 503 (e.g., the third segment) may be disposed in the x-axis direction of the housing 1801. For example, the first conductive portion 510 may be disposed between the first non-conductive portion 501 (e.g., the first segment) and the second non-conductive portion 502 (e.g., the second segment), the second conductive portion 520 may be disposed in the -y-axis direction of the housing 1801 based on the third non-conductive portion 503 (e.g., the third segment), and the third conductive portion 530 may be disposed between the second non-conductive portion 502 (e.g., the second segment) and the third non-conductive portion 503 (e.g., the third segment). For example, the first switch SW1, the second switch SW2, the matching circuit M, the wireless communication module 192, and the processor 120 may be configured to be substantially identical to the embodiments shown in FIG. 18.

The electronic device 200 (e.g., a foldable electronic device) according to an embodiment of the disclosure may include a hinge module 320, a first housing 210 having at least a portion coupled to a first side of the hinge module 320, a printed circuit board 270 which is disposed inside the first housing 210 and includes a wireless communication module 192, a processor 120, and a ground G, and a second housing 220 having at least a portion coupled to a second side of the hinge module 320 and configured to be unfoldable and foldable with respect to the first housing 210 using the hinge module 320. According to an embodiment, the first housing 210 may include a first conductive portion 510, a second conductive portion 520, and a third conductive portion 530 which are electrically connected to the wireless communication module 192, a first non-conductive portion 501 disposed between the first conductive portion 510 and the third conductive portion 530, and a second non-conductive portion 502 disposed between the second conductive portion 520 and the third conductive portion 530. According to an embodiment, the third conductive portion 530 may be electrically connected to a first matching circuit M1 through a first point P1, and the first matching circuit M1 may be electrically connected to the processor 120 through a first electrical path 531.

According to an embodiment, while the first conductive portion 510 operates to radiate signals in a first frequency band and the second conductive portion 520 operates to radiate signals in the first frequency band, the processor 120 may control an impedance of the first matching circuit M1 to correspond to a first impedance.

According to an embodiment, while the first conductive portion 510 operates to radiate signals in a second frequency band and the second conductive portion 520 operates to radiate signals in the second frequency band, the processor 120 may control an impedance of the first matching circuit M1 to correspond to a second impedance.

According to an embodiment, the first matching circuit M1 may include a switch 810 including at least one of a first contact point 811, a second contact point 812, a third contact point 813, and a fourth contact point 814, and at least one of a first lumped element 821, a second lumped element 822, a third lumped element 823, and a fourth lumped element 824.

According to an embodiment, in case that the first matching circuit M1 is controlled by the processor 120 to correspond to the first impedance, with respect to the first matching circuit M1, at least one of the first contact point 811, the second contact point 812, and the third contact point 813 may be turned on, and the third conductive portion 530 may be electrically connected to the ground G through at least one of the first lumped element 821, the second lumped element 822, and the third lumped element 823.

According to an embodiment, in case that the first matching circuit M1 is controlled by the processor 120 to correspond to the second impedance, with respect to the first matching circuit M1, the fourth contact point 814 may be turned on, and the third conductive portion 530 may be electrically connected to the ground G through the fourth lumped element 824.

The second conductive portion 520 may be electrically connected to a second matching circuit M2 through a second point P2.

According to an embodiment, while the second matching circuit M2 is electrically connected to the processor 120 through a second electrical path 525 and the second conductive portion 520 operates to radiate signals in the first frequency band, the processor 120 may control an impedance of the second matching circuit M2 to correspond to a third impedance.

According to an embodiment, while the second conductive portion 520 operates to radiate signals in the second frequency band, the processor 120 may control an impedance of the second matching circuit M2 to correspond to a fourth impedance.

According to an embodiment, the second matching circuit M2 may include a switch 810 including at least one of a first contact point 811, a second contact point 812, a third contact point 813, and a fourth contact point 814, and at least one of a first lumped element 821, a second lumped element 822, a third lumped element 823, and a fourth lumped element 824.

According to an embodiment, in case that the second matching circuit M2 is controlled by the processor 120 to correspond to the third impedance, with respect to the second matching circuit M2, at least one of the first contact point 811, the second contact point 812, and the third contact point 813 may be turned on, and the second conductive portion 520 may be electrically connected to the ground G through at least one of the first lumped element 821, the second lumped element 822, and the third lumped element 823.

According to an embodiment, in case that the second matching circuit M2 is controlled by the processor 120 to correspond to the fourth impedance, with respect to the second matching circuit M2, the fourth contact point 814 may be turned on, and the second conductive portion 520 may be electrically connected to the ground G through the fourth lumped element 824.

According to an embodiment, a first switch SW1 disposed between the first conductive portion 510 and the wireless communication module 192 may be further included, and the first switch SW1 may be configured to provide, to the first conductive portion 510, signals in the first frequency band or signals in the second frequency band transferred through the wireless communication module 192.

According to an embodiment, a second switch SW2 disposed between the second conductive portion 520 and the wireless communication module 192 may be further included, and the second switch SW2 may be configured to provide, to the second conductive portion 520, signals in the first frequency band or signals in the second frequency band transferred through the wireless communication module 192.

According to an embodiment, the first conductive portion 510 may be configured to operate as a legacy antenna or a satellite antenna, the second conductive portion 520 may be configured to operate as a legacy antenna or a satellite antenna, and the third conductive portion 530 may be configured to operate as a legacy antenna.

According to an embodiment, the second housing 220 may include a fourth conductive portion 540, a fifth conductive portion 550, a sixth conductive portion 560, a fourth non-conductive portion 504 disposed between the fourth conductive portion 540 and the sixth conductive portion 560, and a fifth non-conductive portion 505 disposed between the fifth conductive portion 550 and the sixth conductive portion 560, wherein the fifth conductive portion 550 may be configured to be electrically connected to a third matching circuit M3 through a third point P3, the third matching circuit M3 may be configured to be electrically connected to the processor 120 through a third electric path 553, and the processor 120 may be configured to control an impedance of the third matching circuit M3 to suppress a current flowing through the fifth conductive portion 550.

According to an embodiment, the fourth conductive portion 540 and the sixth conductive portion 560 may configured to be electrically connected to a fourth matching circuit M4, the fourth matching circuit M4 may be configured to be electrically connected to the processor 120 through a fourth electric path 544, and the processor 120 may be configured to control an impedance of the fourth matching circuit M4 to suppress a current flowing through the fourth conductive portion 540 and the sixth conductive portion 560.

According to an embodiment, in case that the electronic device 200 is in the unfolding state, the processor 120 may control an impedance of at least one of the first matching circuit M1 and the second matching circuit M2.

According to an embodiment, in case that the electronic device 200 is in the folding state, the processor 120 may control an impedance of the first matching circuit M1 and/or the second matching circuit M2 and the third matching circuit M3 and/or the fourth matching circuit M4.

An electronic device 1800 according to an embodiment may include a housing 1801 including a printed circuit board 270 including a wireless communication module 192, a processor 120, and a ground G, a first conductive portion 510, a second conductive portion 520, and a third conductive portion 530 which are electrically connected to the wireless communication module 192, a first non-conductive portion 501 disposed between the first conductive portion 510 and the third conductive portion 530, and a second non-conductive portion 502 disposed between the second conductive portion 520 and the third conductive portion 530. According to an embodiment, the third conductive portion 530 may be electrically connected to a matching circuit M through a first point P1, and the matching circuit M may be electrically connected to the processor 120 through an electrical path 531.

According to an embodiment, while the first conductive portion 510 operates to radiate signals in a first frequency band and the second conductive portion 520 operates to radiate signals in the first frequency band, the processor 120 may control an impedance of the matching circuit M to correspond to a first impedance.

According to an embodiment, while the first conductive portion 510 operates to radiate signals in a second frequency band and the second conductive portion 520 operates to radiate signals in the second frequency band, the processor 120 may control an impedance of the matching circuit M to correspond to a second impedance.

According to an embodiment, the matching circuit M may include a switch 810 including at least one of a first contact point 811, a second contact point 812, a third contact point 813, and a fourth contact point 814, and at least one of a first lumped element 821, a second lumped element 822, a third lumped element 823, and a fourth lumped element 824.

According to an embodiment, in case that the matching circuit M is controlled by the processor 120 to correspond to the first impedance, with respect to the matching circuit M, at least one of the first contact point 811, the second contact point 812, and the third contact point 813 may be turned on, and the third conductive portion 530 may be electrically connected to the ground G through at least one of the first lumped element 821, the second lumped element 822, and the third lumped element 823.

According to an embodiment, in case that the matching circuit M is controlled by the processor 120 to correspond to the second impedance, with respect to the matching circuit M, the fourth contact point 814 may be turned on, and the third conductive portion 530 may be electrically connected to the ground G through the fourth lumped element 824.

According to an embodiment, the first conductive portion 510 may be configured to operate as a legacy antenna or a satellite antenna, the second conductive portion 520 may be configured to operate as a legacy antenna or a satellite antenna, and the third conductive portion 530 may be configured to operate as a legacy antenna.

In the above, the disclosure has been described according to various embodiments of the disclosure, but it would be obvious that changes and modifications made by a person skilled in the art to which the disclosure pertains without departing from the technical aspect of the disclosure also belong to the disclosure.

## Claims

1. An electronic device (200) comprising:
a hinge module (320);
a first housing (210) having at least a portion coupled to a first side of the hinge module (320);
a printed circuit board (270) which is disposed inside the first housing (210) and comprises a wireless communication module (192), a processor (120), and a ground (G); and
a second housing (220) having at least a portion coupled to a second side of the hinge module (320) and configured to be unfoldable and foldable with respect to the first housing (210) using the hinge module (320),
wherein the first housing (210) comprises:
a first conductive portion (510), a second conductive portion (520), and a third conductive portion (530) which are electrically connected to the wireless communication module (192);
a first non-conductive portion (501) disposed between the first conductive portion (510) and the third conductive portion (530); and
a second non-conductive portion (502) disposed between the second conductive portion (520) and the third conductive portion (530),
wherein the third conductive portion (530) is configured to be electrically connected to a first matching circuit (M1) through a first point (P1),
wherein the first matching circuit (M1) is configured to be electrically connected to the processor (120) through a first electrical path (531),
wherein the processor (120) is configured to control an impedance of the first matching circuit (M1) to correspond to a first impedance while the first conductive portion (510) operates to radiate signals in a first frequency band and the second conductive portion (520) operates to radiate signals in the first frequency band, and
wherein the processor (120) is configured to control an impedance of the first matching circuit (M1) to correspond to a second impedance while the first conductive portion (510) operates to radiate signals in a second frequency band and the second conductive portion (520) operates to radiate signals in the second frequency band.

2. The electronic device of claim 1, wherein the first matching circuit (M1) comprises:
a switch (810) comprising at least one of a first contact point (811), a second contact point (812), a third contact point (813), and a fourth contact point (814); and
at least one of a first lumped element (821), a second lumped element (822), a third lumped element (823), and a fourth lumped element (824).

3. The electronic device of claim 2, wherein the electronic device is configured such that, in case that the first matching circuit (M1) is controlled by the processor (120) to correspond to the first impedance,
in the first matching circuit (M1), at least one of the first contact point (811), the second contact point (812), and the third contact point (813) is turned on, and
the third conductive portion (530) is electrically connected to the ground (G) through at least one of the first lumped element (821), the second lumped element (822), and the third lumped element (823).

4. The electronic device of claim 2 or 3, wherein the electronic device is configured such that, in case that the first matching circuit (M1) is controlled by the processor (120) to correspond to the second impedance,
in the first matching circuit (M1), the fourth contact point (814) is turned on, and
the third conductive portion (530) is electrically connected to the ground (G) through the fourth lumped element (824).

5. The electronic device of one of claims 1 to 4, wherein the second conductive portion (520) is electrically connected to a second matching circuit (M2) through a second point (P2),
wherein the second matching circuit (M2) is electrically connected to the processor (120) through a second electrical path (525), and
wherein the processor (120) is configured to control an impedance of the second matching circuit (M2) to correspond to a third impedance while the second conductive portion (520) operates to radiate signals in the first frequency band.

6. The electronic device of claim 5, wherein the processor (120) is configured to control an impedance of the second matching circuit (M2) to correspond to a fourth impedance while the second conductive portion (520) operates to radiate signals in the second frequency band.

7. The electronic device of claim 6, wherein the second matching circuit (M2) comprises:
a switch (810) comprising at least one of a first contact point (811), a second contact point (812), a third contact point (813), and a fourth contact point (814); and
at least one of a first lumped element (821), a second lumped element (822), a third lumped element (823), and a fourth lumped element (824).

8. The electronic device of claim 7, wherein the electronic device is configured such that, in case that the second matching circuit (M2) is controlled by the processor (120) to correspond to the third impedance,
in the second matching circuit (M2), at least one of the first contact point (811), the second contact point (812), and the third contact point (813) is turned on, and
the second conductive portion 520 is electrically connected to the ground G through at least one of the first lumped element (821), the second lumped element (822), and the third lumped element (823).

9. The electronic device of claim 7, wherein the electronic device is configured such that, in case that the second matching circuit (M2) is controlled by the processor (120) to correspond to the fourth impedance,
in the second matching circuit (M2), the fourth contact point (814) is turned on, and
the second conductive portion (520) is electrically connected to the ground (G) through the fourth lumped element (824).

10. The electronic device of one of claims 1 to 9, further comprising a first switch (SW1) disposed between the first conductive portion (510) and the wireless communication module (192),
wherein the first switch (SW1) is configured to provide, to the first conductive portion (510), signals in the first frequency band or signals in the second frequency band transferred through the wireless communication module (192).

11. The electronic device of one of claims 1 to 10, further comprising a second switch (SW2) disposed between the second conductive portion (520) and the wireless communication module (192),
wherein the second switch (SW2) is configured to provide, to the second conductive portion (520), signals in the first frequency band or signals in the second frequency band transferred through the wireless communication module (192).

12. The electronic device of one of claims 1 to 11, wherein the first conductive portion (510) is configured to operate as a legacy antenna or a satellite antenna,
wherein the second conductive portion (520) is configured to operate as a legacy antenna or a satellite antenna, and
wherein the third conductive portion (530) is configured to operate as a legacy antenna.

13. The electronic device of one of claims 1 to 12, wherein the second housing (220) comprises:
a fourth conductive portion (540), a fifth conductive portion (550), and a sixth conductive portion (560);
a fourth non-conductive portion (504) disposed between the fourth conductive portion (540) and the sixth conductive portion (560); and
a fifth non-conductive portion (505) disposed between the fifth conductive portion (550) and the sixth conductive portion (560),
wherein the fifth conductive portion (550) is electrically connected to a third matching circuit (M3) through a third point (P3),
wherein the third matching circuit (M3) is electrically connected to the processor (120) through a third electrical path (553), and
wherein the processor (120) is configured to control an impedance of the third matching circuit (M3) so as to suppress a current flowing through the fifth conductive portion (550).

14. The electronic device of claim 13, wherein the fourth conductive portion (540) and the sixth conductive portion (560) are electrically connected to a fourth matching circuit (M4),
wherein the fourth matching circuit (M4) is electrically connected to the processor (120) through a fourth electric path (544), and
wherein the processor (120) is configured to control an impedance of the fourth matching circuit (M4) so as to suppress a current flowing through the fourth conductive portion (540) and the sixth conductive portion (560).

15. The electronic device of claim 14, wherein the processor (120) is configured to, in case that the electronic device (200) is in an unfolding state, control an impedance of at least one of the first matching circuit (M1) and the second matching circuit (M2), and
wherein the processor (120) is configured to, in case that the electronic device (200) is in a folding state, control an impedance of the first matching circuit (M1) and/or the second matching circuit (M2) and the third matching circuit (M3) and/or the fourth matching circuit (M4).
